# EUROPEAN PATENT SPECIFICATION

(11) **EP 1 695 821 B1**
(45) Date of publication and mention of the grant of the patent: **12.12.2007**
(21) Application number: 06003687.8
(22) Date of filing: 23.02.2006
(51) Int. Cl.: B41C 1/10, G03F 7/075

(54) **Planographic printing plate precursor**
Flachdruckplattenvorläufer
Précurseur de plaque d'impression planographique

(30) Priority: 25.02.2005 JP 2005051837
(43) Date of publication of application: 30.08.2006
(73) Proprietor: FUJIFILM Corporation, Minato-ku Tokyo (JP)
(72) Inventor: Kakino, Ryuki, Yoshida-cho Haibara-gun Shizuoka-ken (JP)
(74) Representative: HOFFMANN EITLE

(56) References cited:
- US-A- 4 259 905
- US-A- 5 310 869
- US-A1- 2004 053 163

## Description

### BACKGROUND OF THE INVENTION

### Field of the Invention

The present invention relates to a photosensitive planographic printing plate precursor which can provide a photosensitive planographic printing plate precursor that exhibits excellent inking property and does not produce deposits such as sludge in a developing solution during a plate-making process.

### Description of the Related Art

A planographic printing plate precursor has a structure comprising a substrate and an image-forming composition provided thereon.

A typical production process includes suitable surface-treatment, applying a primer layer or a back-coating on the surface of a substrate, applying an image-forming layer comprised of an image-forming composition dispersed or dissolved in an organic solvent on the substrate and drying the image-forming layer, and applying an upper layer such as a protective layer on the image-forming layer as the need arises.

A typical plate-making process includes generating physical change in the imagewise forms in the image-forming composition that was applied on the substrate by adhesive or a projection-type surface light-exposure through an image mask, or by direct exposure via scanning and modulation of electromagnetic waves based on image information from a computer; removing the image-forming composition from the non-image portion (development); and treating the surface by providing hydrophilicity, oil sensitivity, or a protective layer, as the need arises, to form a planographic printing plate having a non-image portion comprising a hydrophilic substrate surface layer and an image portion comprising a hydrophobic substrate surface layer.

The planographic printing plate thus obtained is used in a typical printing process wherein the hydrophilic non-image portion accepts dampening water and the lipophilic image portion accepts ink to form an ink image on the surface. The ink image thus obtained is transferred directly or indirectly onto the desired printing medium to give a printed product.

As a recording layer (image-forming layer) for use in a planographic printing plate precursor, a positive photosensitive layer to which a heat mode process is applied is useful. Various techniques for a positive photosensitive layer, such as that which employs a thermosensitive recording method, are already known. When using the above-mentioned image-forming layer, it is necessary to provide sufficient lipophilicity on the surface of the photosensitive layer to form a fine ink image on the surface, and improving inking property at the start of printing is useful for remarkably improving the operation efficiency of printing.

However, when the surface of the photosensitive layer is made lipophilic to improve inking property, development property usually decreases because permeability of a developing solution into the photosensitive layer decreases. Therefore, a material having balanced hydrophilicity and lipophilicity would be used to impart both development property and inking property, but there is no material which has a capability of sufficiently satisfying both hydrophilicity and lipophilicity.

As a method of ensuring lipophilicity on a surface of a photosensitive layer, a method that uses a lipophilic polymer having a straight chain, a branched chain or a cyclic alkyl group having 4 to 20 carbon atoms, such as phenolic hydroxyl group and stearyl group, has been proposed (Japanese Patent Application Laid-Open (JP-A) No. 2004-117882). However, when using the above-mentioned lipophilic polymer as a binder, the amount of the polymer to be added increases, which has a significant impact on other properties, making their effective use difficult. In addition, the method has a problem that the inking property deteriorates when these lipophilic polymers are used as an additive.

Furthermore, a method comprising adding a fluorine-based surfactant having a fluoroaliphatic group is known in the disclosures of JP-A-2002-311577 and JP-A-2004-10189. However, these method have problems that an improvement of inking property cannot be achieved even if these fluorine-based surfactants are used, and sensitivity is decreased and sludge is produced in the developing solution when a large amount of these fluorine-based surfactants is used with the aim of improving the inking property.

US-A-4 259 905 discloses a waterless planographic printing plate comprising a substrate and an overlying layer, the overlying layer comprising the reaction product of an organopolysiloxane having hydroxyl end groups and a polymeric material. The overlying layer is imaged with toner particles which are then cured to form areas of ink receptivity. The printing plate is then used for printing without the need for a fountain solution.

US-A-5 310 869 teaches a recording medium capable of being imaged using ablative discharge. The medium comprises a substrate provided with a cured polymeric silicone matrix composition.

### SUMMARY OF THE INVENTION

The object of the present invention is to provide a photosensitive planographic printing plate precursor which provides excellent inking property on the image portion and suppresses production of deposits such as sludge in a developing solution during the plate-making process.

The inventors of the present invention have, after conducting intensive studies, found that the above-mentioned problems can be solved by incorporating a polymer compound having particular partial structures into a recording layer of a photosensitive planographic printing plate precursor, resulting in the completion of the present invention.

Namely, the planographic printing plate precursor of the invention comprises a substrate, and a recording layer provided on the substrate, the recording layer comprising a polymer compound having partial structures represented by the following (1) and (2):
(1) silicon-oxygen bonds, and
(2) alkali-soluble groups.

The recording layer of the photosensitive planographic printing plate precursor of the present invention further comprises an infrared-lightabsorbing agent.

Although the mechanism of action which improves inking property on the image portion and allows suppression of production of sludge in the developing solution during the plate-forming process is not clear in the present invention, it can be assumed as follows.

Namely, the silicon-oxygen bonds included in the particular polymer compound are preferably partial structures having a hydrocarbon group such as a methyl group. In the recording layer, the image portion can exhibit fine inking property due to an uneven distribution of such partial structures on the surface of the recording layer.

Furthermore, since the particular polymer compound comprises an alkali-soluble group, it is thought that the particular polymer compound included in the recording layer, which is to be removed as a non-image portion, can be readily dissolved in the developing solution during the plate-making process to thereby effectively suppress production of deposits such as sludge in the developing solution.

To summarize the above, the photosensitive planographic printing plate precursor according to the present invention can exhibit excellent inking property on the image portion and can suppress production of deposits such as sludge in a developing solution during the plate-making process.

### DETAILED DESCRIPTION OF THE INVENTION

Hereinafter, the present invention is explained in detail.

The photosensitive planographic printing plate precursor of the present invention comprises a substrate and a recording layer provided on the substrate, the recording layer comprises a polymer compound having a partial structure represented by the following (1) and (2):
(1) silicon-oxygen bonds, and
(2) alkali-soluble groups.

### (Particular polymer compound)

The particular polymer compound has (1) silicon-oxygen bonds and (2) alkali-soluble groups as partial structures, and the particular polymer compound is not specifically limited as long it has these partial structures.

In the particular polymer compound, the silicon-oxygen bonds may exist as a part of a group of atoms which constitutes the polymer main chain or as a part of a group of atoms which constitutes a polymer side chain in the polymer compound.

It is necessary for one or more silicon-oxygen bonds to be included in the particular polymer compound, and the inclusion of the silicon-oxygen bonds as a repeating structure, of which 3 or more (preferably 5 to 10,000, inclusive; more preferably, 8 to 2000, inclusive) bonds in the particular polymer compound is preferable. The inclusion of a repeating structure in the silicon-oxygen bonds incorporated in the particular polymer compound allows the recording layer to be constituted so that the silicon concentration in the recording layer is higher at the surface of the recording layer, and is lower in the vicinity of the substrate.

The partial structure comprising silicon-oxygen bonds preferably comprises a lipophilic group. Preferable examples of the lipophilic group comprise an alkyl group, an alkenyl group, an alkynyl group, an aryl group and a heterocyclic group, each of which optionally has substituent(s), and more preferable examples comprise an alkyl group and an aryl group.

The content of silicon atoms in the particular polymer compound is preferably 1.0 mmol/g or more in view of increasing eccentricity of the particular polymer compound on the surface, and is more preferably 3 mmol/g or more.

The monomer for forming the silicon-oxygen bond in the particular polymer compound is not specifically limited, and examples thereof include a monomer having silicon-oxygen bond and a monomer having a partial structure which can contribute to the formation of a silicon-oxygen bond. Examples thereof include the following compounds:

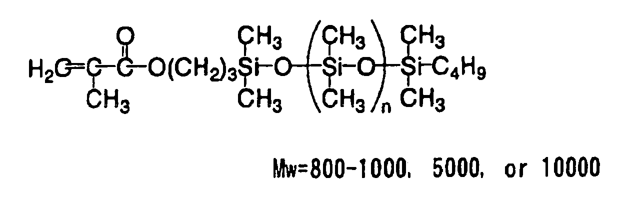

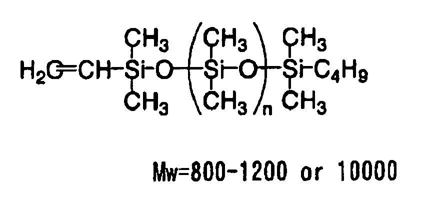

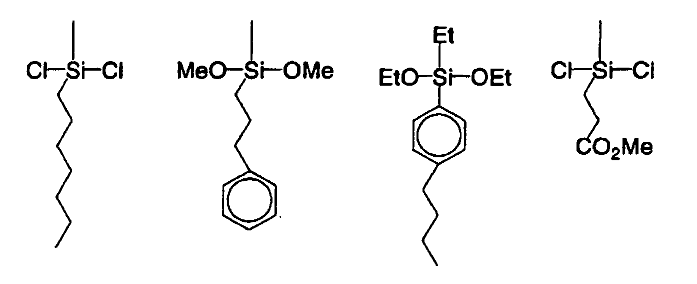

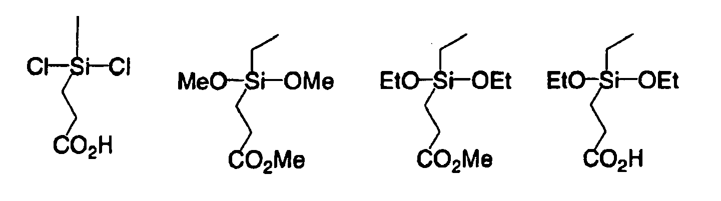

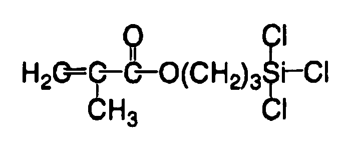

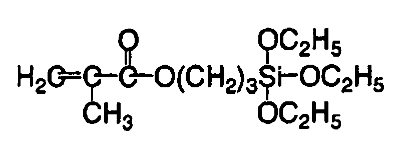

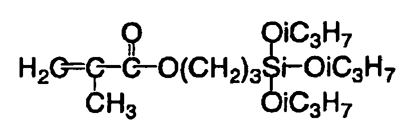

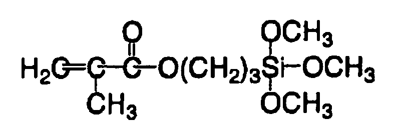

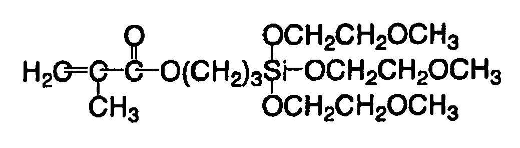

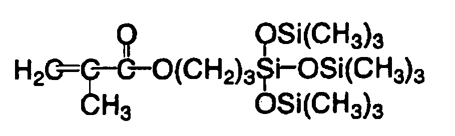

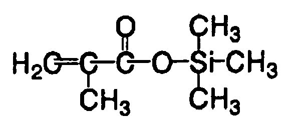

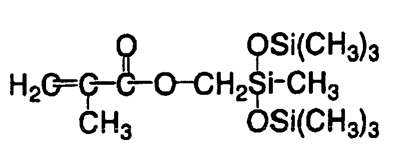

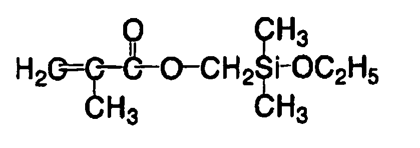

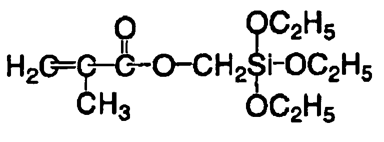

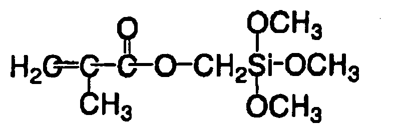

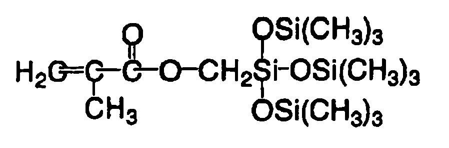

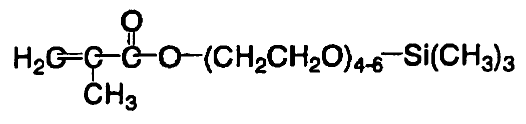

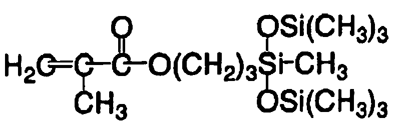

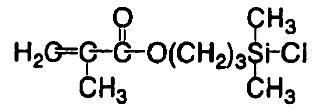

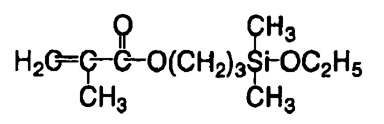

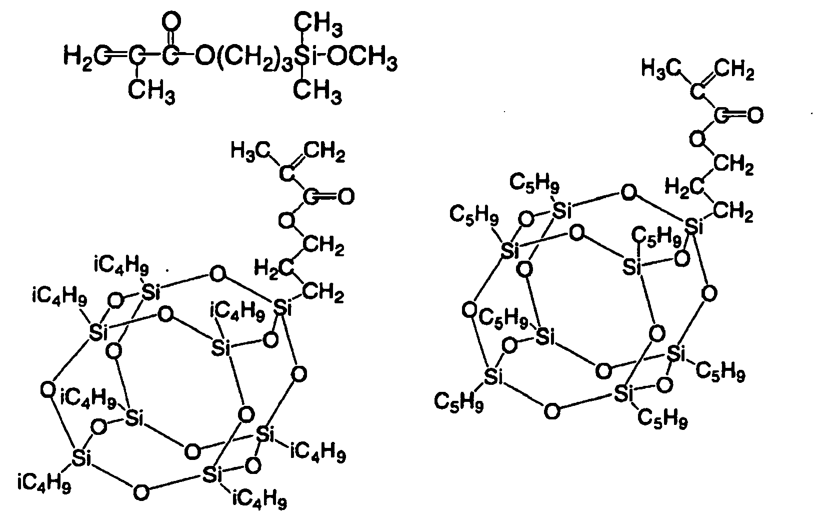

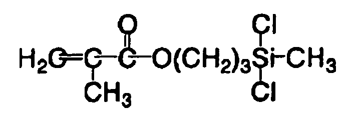

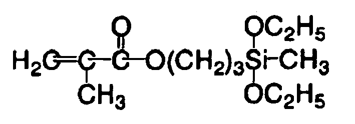

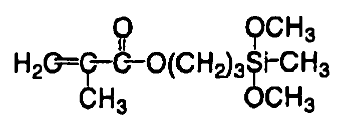

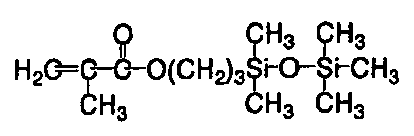

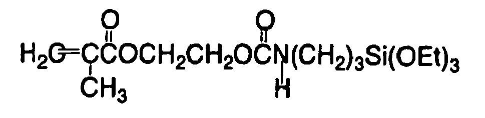

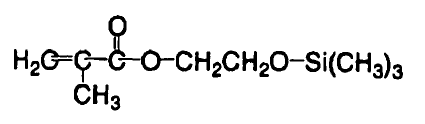

The particular polymer compound used in the present invention comprises those having an alkali-soluble group as a partial structure, together with the above-mentioned silicon-oxygen bonds. In the particular polymer compound, the alkali-soluble group may exist as a part of a group of atoms which constitutes the polymer main chain or as a part of a group of atoms which constitutes a polymer side chain in the polymer compound.

The particular polymer compound is preferably obtained by copolymerizing the above-mentioned monomer for forming a silicon-oxygen bond and a monomer having an alkali-soluble group. Alternatively, the particular polymer compound may be obtained by polymerizing a monomer having a silicon-oxygen bond to give a polymer compound having silicon-oxygen bonds, and then modifying the polymer by introducing an alkali-soluble group.

The monomer having alkali-soluble group is not specifically limited so long as it is a monomer having one or more polymerizable unsaturated group(s) and one or more alkali-soluble group(s) in the molecule. Preferably, a monomer comprising any of the acid groups explained below is included in the particular polymer compound as a component for copolymerization.
(1) phenol group (-Ar-OH)
(2) sulfonamide group (-SO₂NH-R)
(3) substituted sulfonamide-based acid group (hereinafter, referred to as "active imide group")

   [-SO₂-NHCOR, -SO₂NHSO₂R, -CONHSO₂R]
(4) carboxylic acid group (-CO₂H)
(5) sulfonic acid group (-SO₃H)
(6) phospholic acid group (-OPO₃H₂)

In the above-mentioned (1) to (6), Ar is a bivalent aryl linking group optionally having substituent(s), and R is hydrogen atom or hydrocarbon group optionally having substituent(s).

Among the compounds having an acid group selected from the above-mentioned (1) to (6), those having (1) a phenol group, (2) a sulfonamide group and (4) a carboxylic acid group are preferable in view of the effect, and that having (4), a carboxylic acid group, is the most preferable in view of assuring sufficient inking property and development property.
(1) Examples of a monomer having a phenolic hydroxyl group include a monomer having a hydroxyaryl group in the side chain.
   Examples of the monomer having a hydroxyaryl group in the side chain include monomers comprising at least one kind of a monomer represented by the following formula (a): 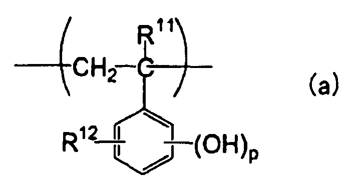
   In formula (a), R¹¹ is a hydrogen atom or a methyl group, R¹² is a hydrogen atom, a halogen atom, a hydrocarbon group having 10 or less carbon atoms, an alkoxy group having 10 or less carbon atoms, or an aryloxy group having 10 or less carbon atoms, and p is an integer of 1 to 3.
(2) Examples of a polymer having a sulfonamide group include a polymer constituted by a minimum constitutional unit derived from a compound having a sulfonamide group as a main structural component. Examples of such compounds include a compound having one or more sulfonamide group(s) in which at least one hydrogen atom is bonded to the nitrogen atom, and one or more of polymerizable unsaturated group(s) in the molecule. Among these, a low molecular weight compound comprising an acryloyl group, an allyl group or a vinyloxy group, a substituted or monosubstituted aminosulfonyl group, or a substituted sulfonylimino group in the molecule is preferable. Examples of the compounds include the compounds represented by formulas (i) to (v) below.

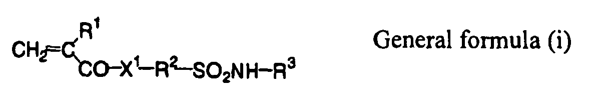

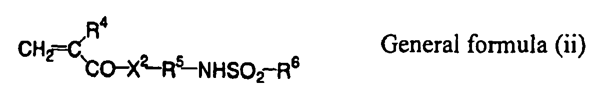

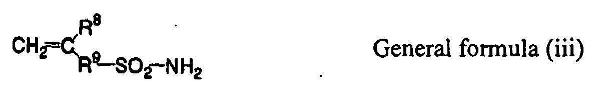

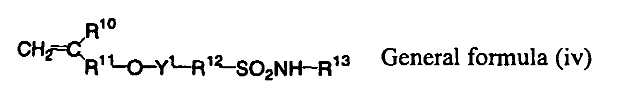

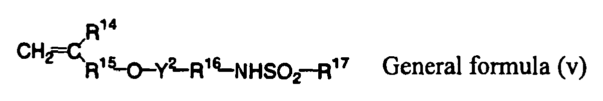

In the general formulae (i) to (v), X¹ and X² each independently represent -O-, or -NR⁷-; R¹ and R⁴ each independently represent a hydrogen atom, or -CH₃; R², R⁵, R⁹, R¹² and R¹⁶ each independently represent an alkylene, cycloalkylene, arylene or aralkylene group which may have a substituent and has 1 to 12 carbon atoms; R³, R⁷ and R¹³ each independently represent a hydrogen atom, or an alkyl, cycloalkyl, aryl or aralkyl group which may have a substituent and has 1 to 12 carbon atoms; R⁶ and R¹⁷ each independently represent an alkyl, cycloalkyl, aryl or aralkyl group which may have a substituent and has 1 to 12 carbon atoms; R⁸, R¹⁰ and R¹⁴ each independently represent a hydrogen atom or -CH₃; R¹¹ and R¹⁵ each independently represent a single bond, or an alkylene, cycloalkylene, arylene or aralkylene group which may have a substituent and has 1 to 12 carbon atoms; and Y¹ and Y² each independently represent a single bond or -CO-.

Examples of the alkali-soluble structural unit having an active imide group in the item (3) include minimum constituent unit derived from compounds having an active imide group. Examples of such structural unit include structural units each having in the molecule thereof one or more active imide groups represented by the structural formula below and one or more unsaturated groups which can be polymerized with the active imide group(s):

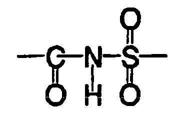

Examples of the alkali-soluble structural unit having a carboxylic acid group in the item (4) include minimum constituent units derived from compounds each having in the molecule thereof one or more carboxylic acid groups and one or more unsaturated groups which can be polymerized with the carboxylic acid group(s).

Examples of the alkali-soluble structural unit having a sulfonic acid group in the item (5) include minimum constituent units derived from compounds each having in the molecule thereof one or more sulfonic acid groups and one or more unsaturated groups which can be polymerized with the sulfonic acid group(s).

Examples of the alkali-soluble structural unit having a phosphoric acid group in the item (6) include minimum constituent units derived from compounds each having in the molecule thereof one or more phosphoric acid group and one or more unsaturated groups which can be polymerized with the phophoric acid group(s).

The monomer having the acid group selected from the above-mentioned (1) to (6), which constitutes the particular polymer compound used for the present invention is not necessarily only one kind, and a particular polymer compound in which two or more of monomers having the same or different acid groups can be introduced as copolymerization components.

The amount of the acid group to be introduced in the particular polymer compound is not specifically limited so long as the polymer compound can be dissolved in an alkali developing solution having a pH of 10 to 13 due to the presence of the acid group.

Also, the most preferable example of the monomer having the acid group which constitutes the particular polymer compound used for the present invention is a monomer which can constitute a repeating unit represented by the following formula (I).

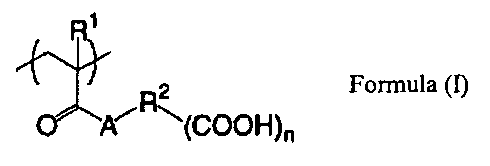

In formula (I), R¹ is a hydrogen atom or a methyl group, and a methyl group is particularly preferable. In formula (I), a linking group represented by R² is a linking group having a substituent(s) wherein the number of atoms in the linking group, excluding the substituent(s), is 2 to 30; specific examples thereof include bivalent groups such as alkylene, substituted alkylene, arylene and substituted arylene, and a group in which a plurality of these groups are linked by amide bonds or ester bonds. For example, a preferable example of the linking group having a chain structure include a structure in which alkylenes such as ethylene and propylene are linked via ester bonds.

Furthermore, a more preferable example of the linking group represented by R² includes a hydrocarbon group of (n+1) valent having an alicyclic structure that has 3 to 30 carbon atoms. Specific examples thereof include compounds having an alicyclic structure such as cyclopropane, cyclopentane, cyclohexane, cycloheptane, cyclooctane, cyclodecane, dicyclohexyl, tercyclohexyl and norbomane. Examples thereof may also include a hydrocarbon group of (n+1) valent obtained by removing (n+1) hydrogen atoms on any of the carbon atoms which constitute a compound having an aliphatic chain structure having 5 to 20 atoms.

Any of the carbon atoms which constitute an alicyclic structure or a chain structure may be substituted by one or more heteroatom(s) selected from nitrogen atoms, oxygen atoms and sulfur atoms.

Examples of the substituents which can be introduced into the linking group represented by R² include a group of monovalent non-metal atoms except a hydrogen atom, such as a halogen atom (-F, -Br, -Cl and -I), a hydroxyl group, an alkoxy group, an aryloxy group, a mercapto group, an aryl group, an alkenyl group and an alkynyl group.

When the A in formula (I) is NR₃-, R₃ is a hydrogen atom or a monovalent hydrocarbon group having 1 to 10 carbon atom(s). Examples of the monovalent hydrocarbon group having 1 to 10 carbon atom(s) represented by R₃ include an alkyl group, an aryl group, an alkenyl group and an alkynyl group.

Examples of the alkyl group include a straight chain, a branched chain, or a cyclic alkyl group having 1 to 10 carbon atom(s) such as a methyl group, an ethyl group, a propyl group, a butyl group, a pentyl group, a hexyl group, a heptyl group, an octyl group, a nonyl group, a decyl group, an isopropyl group, an isobutyl group, a sec-butyl group, a tert-butyl group, an isopentyl group, a neopentyl group, a 1-methylbutyl group, an isohexyl group, a 2-ethylhexyl group, a 2-methylhexyl group, a cyclopentyl group, a cyclohexyl group, a 1-adamantyl group and a 2-norbornyl group.

In formula (I), A is preferably an oxygen atom or -NH- for ease of synthesis.

In formula (I), n is an integer of from 1 to 5, and preferably 1 in view of printing durability.

Hereinafter, the preferable specific examples of the repeating unit represented by formula (I) are shown, but the invention is not limited to these examples.

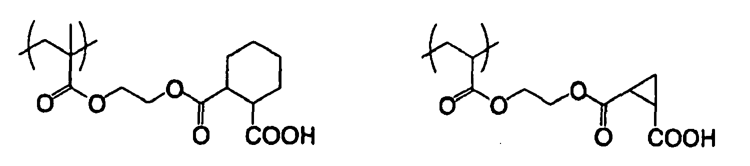

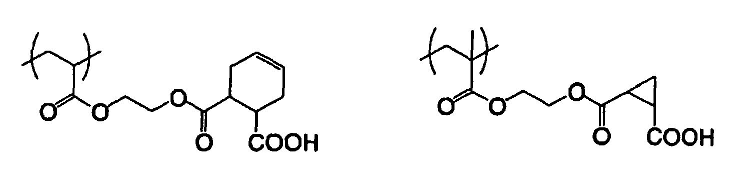

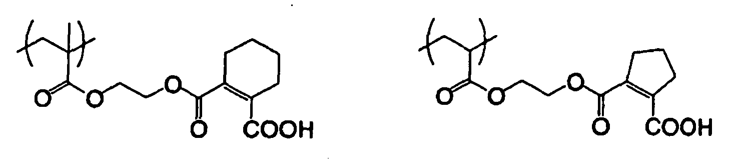

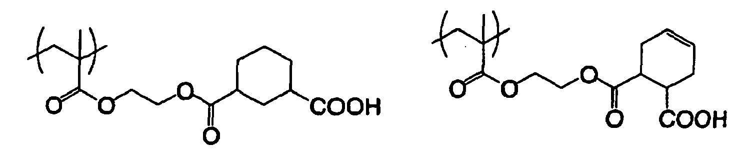

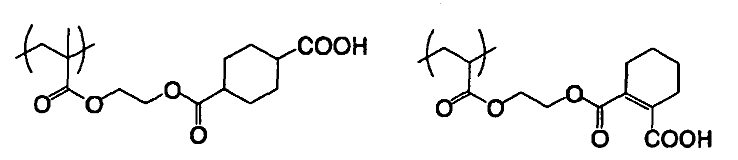

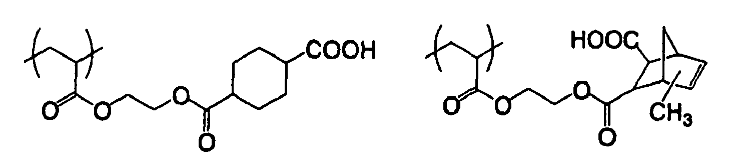

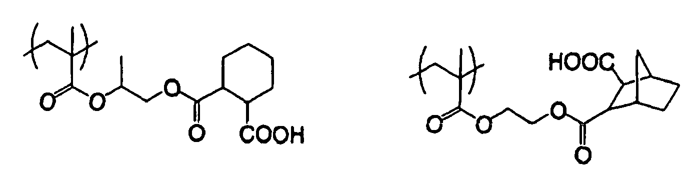

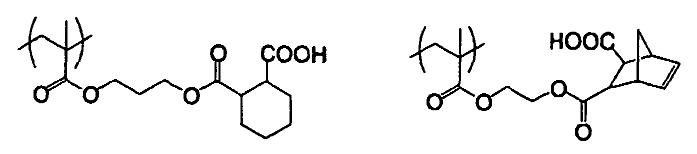

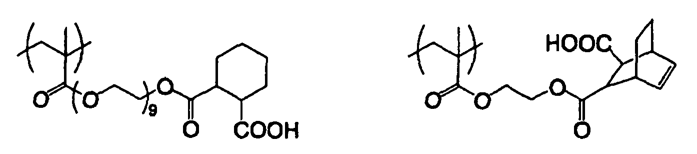

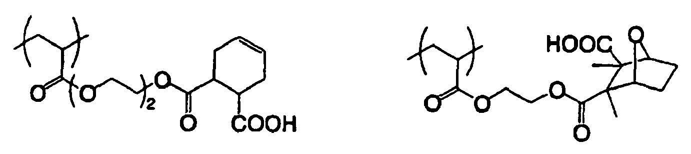

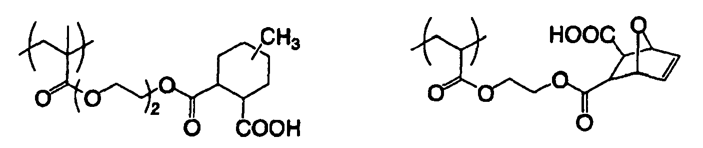

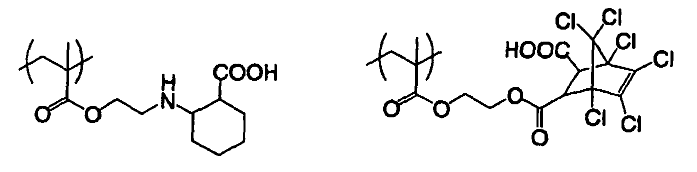

Only one kind, or two or more kinds, of the repeating unit represented by the formula (I) may be included in a binder polymer. When the number of carboxylic groups in the particular polymer compound is too small, sludge is produced in a developing solution. On the other hand, when thereare too many carboxylic groups, a desired inking property cannot be obtained. Therefore, the acid value of the particular polymer compound is preferably 0.1 to 10.0 mmol/g, preferably 0.2 to 5.0 mmol/g, and more preferably 0.3 to 3.5 mmol/g in view of inking property and sensitivity.

In view of improving the inking property and the coating property, and to the extent the effect of the present invention is not lost, the particular polymer compound is preferably a polymer obtained by copolymerizing the above-mentioned monomer for forming a silicon-oxygen bond and a monomer having an alkali-soluble group, and used in combination with another monomer as mentioned below.

Examples of another monomer which can be used in combination include known monomers such as acrylic acid esters, methacrylic acid esters, acrylamides, methacrylamides, vinyl esters, styrenes, acrylonitrile, maleic anhydride and maleimide.

Examples of the acrylic acid esters include methyl acrylate, ethyl acrylate, (n- or i-) propyl acrylate, (n-, i-, sec- or t-) butyl acrylate, amyl acrylate, 2-ethylhexyl acrylate, dodecyl acrylate, chloroethyl acrylate, 2-hydroxyethyl acrylate, 2-hydroxypropyl acrylate, 5-hydroxypentyl acrylate, cyclohexyl acrylate, allyl acrylate, trimethylol propane monoacrylate, pentaerythritol monoacrylate, glycidyl acrylate, benzyl acrylate, methoxybenzyl acrylate, chlorobenzyl acrylate, 2-(p-hydroxyphenyl)ethyl acrylate, furfuryl acrylate, tetrahydrofurfuryl acrylate, phenyl acrylate, chlorophenyl acrylate, sulfamoyl phenyl acrylate, stearyl acrylate and lauryl acrylate.

Examples of the methacrylic acid esters include methyl methacrylate, ethyl methacrylate, (n- or i-) propyl methacrylate, (n-, i-, sec- or t-) butyl methacrylate, amyl methacrylate, 2-ethylhexyl methacrylate, dodecyl methacrylate, chloroethyl methacrylate, 2-hydroxyethyl methacrylate, 2-hydroxypropyl methacrylate, 5-hydroxypentyl methacrylate, cyclohexyl methacrylate, allyl methacrylate, trimethylol propane monomethacrylate, pentaerythritol monomethacrylate, glycidyl methacrylate, methoxybenzyl methacrylate, chlorobenzyl methacrylate, 2-(p-hydroxyphenyl)ethyl methacrylate, furfuryl methacrylate, tetrahydrofurfuryl methacrylate, phenyl methacrylate, chlorophenyl methacrylate, sulfamoyl phenyl methacrylate, stearyl methacrylate and lauryl methacrylate.

Examples of the acrylamides include acrylamide, N-methylacrylamide, N-ethylacrylamide, N-propylacrylamide, N-butylacrylamide, N-benzylacrylamide, N-hydroxyethylacrylamide, N-phenylacrylamide, N-tolylacrylamide, N-(p-hydroxyphenyl)acrylamide, N-(sulfamoylphenyl)acrylamide, N-(phenylsulfonyl)acrylamide, N-(tolylsulfonyl)acrylamide, N,N-dimethylacrylamide, N-methyl-N-phenylacrylamide and N-hydroxyethyl-N-methylacrylamide.

Examples of the methacrylamides include methacrylamide, N-methylmethacrylamide, N-ethylmethacrylamide, N-propylmethacrylamide, N-butylmethacrylamide, N-benzylmethacrylamide, N-hydroxyethylmethacrylamide, N-phenylmethacrylamide, N-tolylmethacrylamide, N-(p-hydroxyphenyl)methacrylamide, N-(sulfamoylphenyl)methacrylamide, N-(phenylsulfonyl)methacrylamide, N-(tolylsulfonyl)methacrylamide, N,N-dimethylmethacrylamide, N-methyl-N-phenylmethacrylamide and N-hydroxyethyl-N-methylmethacrylamide.

Examples of the vinylesters include vinyl acetate, vinyl butylate and vinyl benzoate.

Examples of the styrenes include styrene, methylstyrene, dimethylstyrene, trimethylstyrene, ethylstyrene, propylstyrene, cyclohexylstyrene, chloromethylstyrene, trifluoromethylstyrene, ethoxymethylstyrene, acetoxymethylstyrene, methoxystyrene, dimethoxystyrene, chlorostyrene, dichlorostyrene, bromostyrene, iodostyrene, fluorostyrene and carboxystyrene.

Among these monomers, acrylic esters, methacrylic esters, vinyl esters and styrenes, each of which has 10 or more carbon atoms, are preferable, and acrylic esters and methacrylic esters, each of which has 10 or more carbon atoms and a bridge bond, are particularly preferable.

The particular polymer compound in the recording layer may be used singly, or used in combination as a mixture with one or more of another silicon-based polymer compound(s) or fluorine-based polymer compound(s).

The silicon-based polymer compound or fluorine-based polymer compound which may be used in combination is used in the amount of 0.1 to 80 mass%, preferably in the amount of 1 to 70 mass%, and more preferably in the amount of 1 to 60 mass% based on the total mass of the particular polymer compound. Examples of the silicon-based polymer compound and fluorine-based polymer compound which may be used in combination include, but are not limited to, commercially available polymer compounds, specifically, fluorine-based surfactants which are frequently used in the art, and the fluorine-based polymers and silicone disclosed in JP-A Nos. 2002-311577, 2002-72474, and 2004-101893.

The amount of the particular polymer compound to be included in the recording layer can be decided as deemed appropriate, but is generally in the range of 0.0001 to 30 mass%, preferably in the range of 0.001 to 25 mass%, and more preferably in the range of 0.01 to 20 mass% based on the total mass of the non-volatile component in the recording layer.

The weight-average molecular weight of the particular polymer compound can be decided as deemed appropriate in view of the inking property and development property. Generally, when the molecular weight increases, the inking property becomes excellent, but the amount of sludge in the developing solution increases. Conversely, when the molecular weight decreases, the amount of sludge in the developing solution tends to decrease, but the inking property becomes low. The molecular weight is preferably in the range of 1,000 to 1,000,000, more preferably in the range of 2,000 to 500,000, and more preferably in the range of 3,000 to 300,000. When the weight-average molecular weight of the particular polymer compound is in the above-mentioned ranges, a fine coating property can be obtained, an effect of improved inking property can be exhibited, and the solubility of the particular polymer compound in the coating solvent is good. Therefore, a uniform coated film can be obtained without losing handling properties such as coating property.

The particular polymer compound may have a linear, branched or blocked structure.

Hereinafter, the structures of particular polymer compounds [(P-1) to (P-25)] which are preferable for the present invention and the weight-average molecular weights thereof are exemplified. However, the present invention is not limited to these examples.

| | Mw |
|---|---|
| 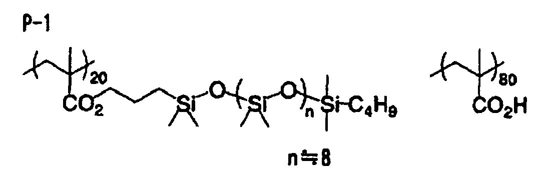 | 35,000 |
| 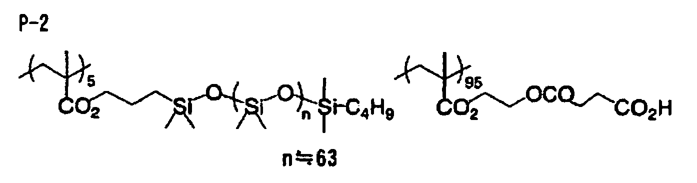 | 46,000 |
| 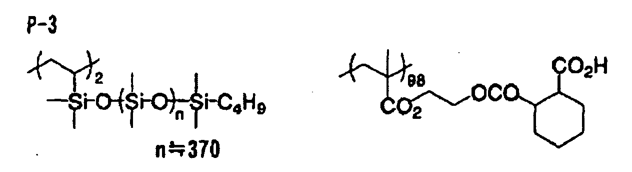 | 62,000 |
| 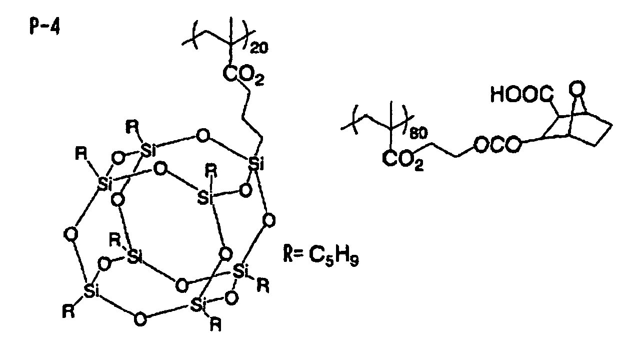 | 56,000 |
| 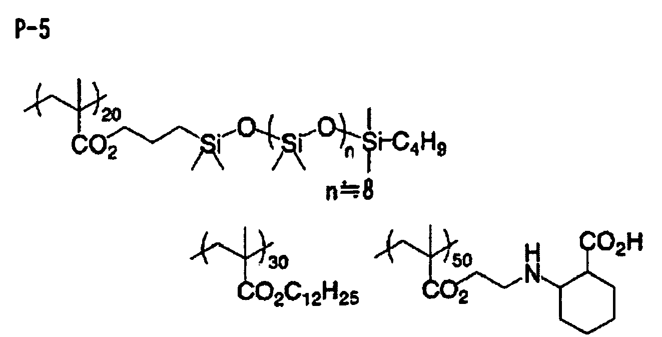 | 47,000 |
| 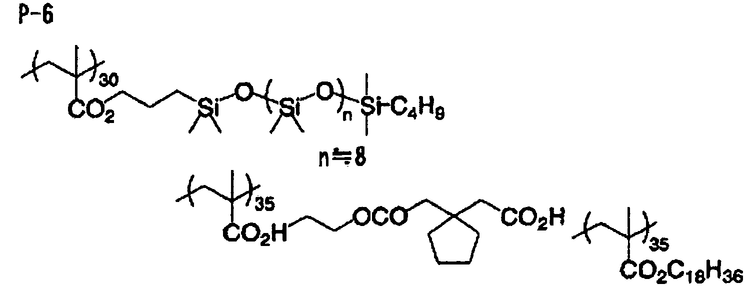 | 52,000 |
| 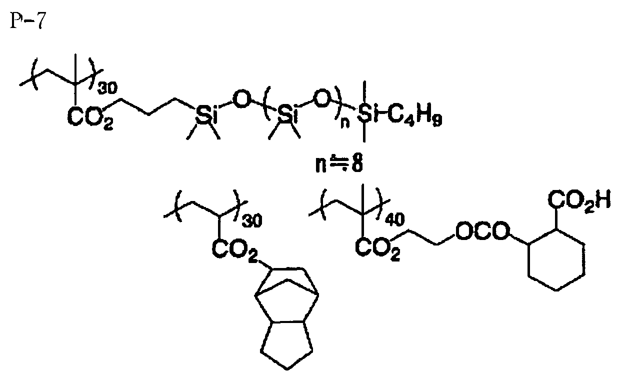 | 52,000 |
| 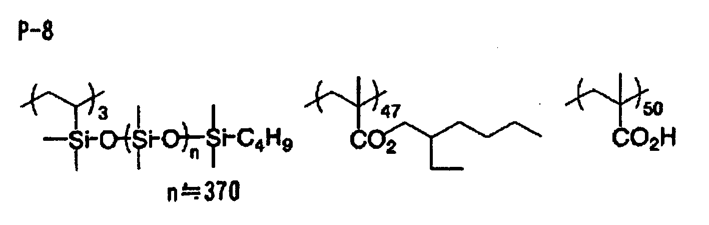 | 39,000 |
| 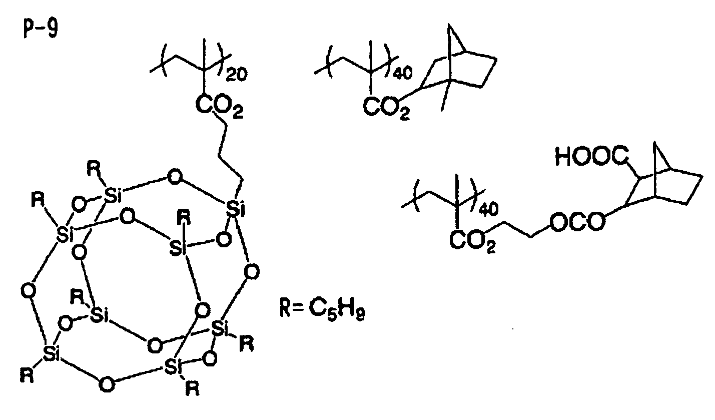 | 28,000 |
| 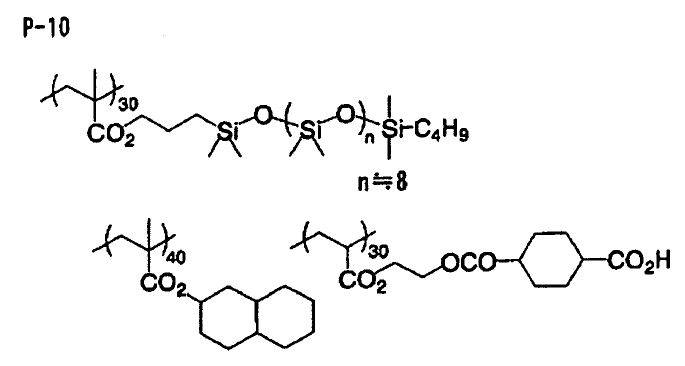 | 36,000 |
| 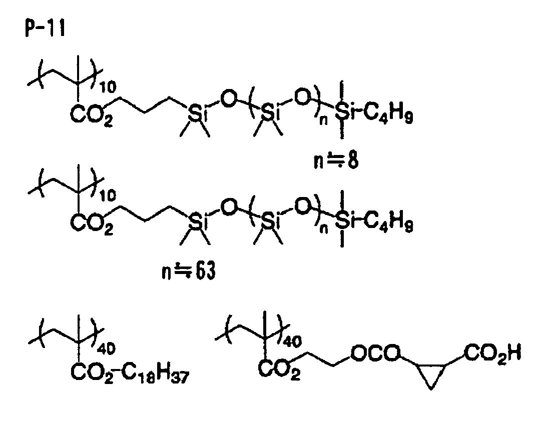 | 41,000 |
| 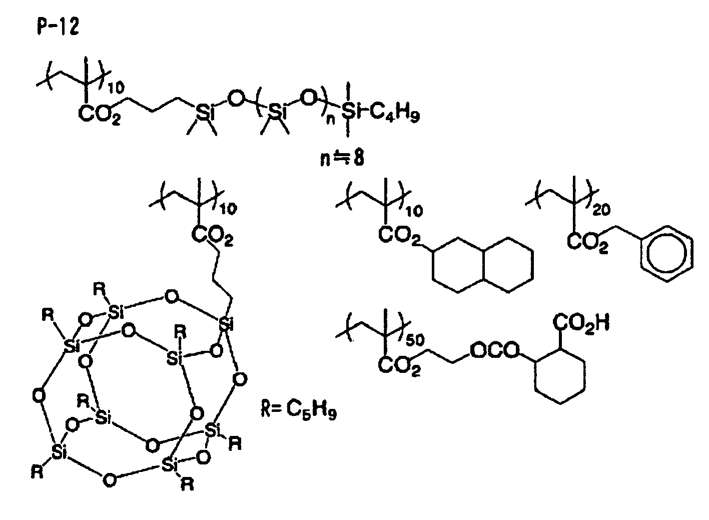 | 39,000 |
| 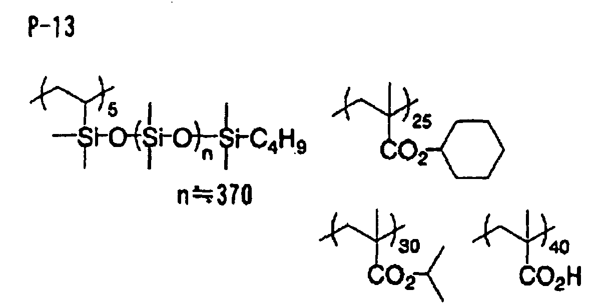 | 47,000 |
| 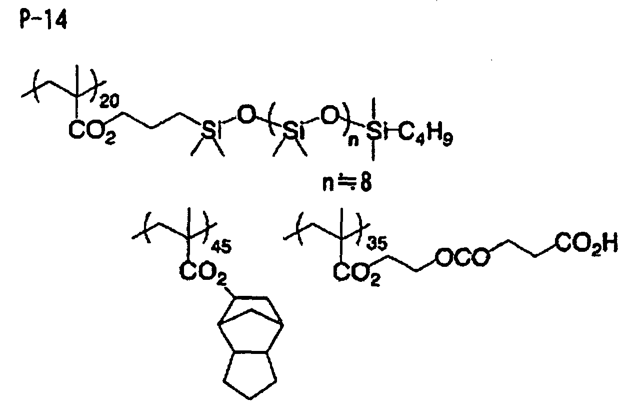 | 56,000 |
| 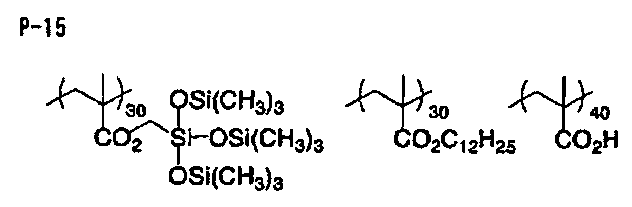 | 52,000 |
| 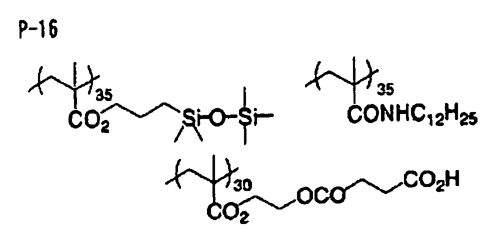 | 46,000 |
| 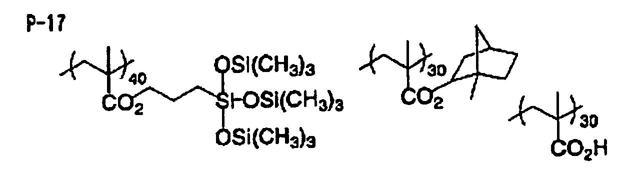 | 48,000 |
| 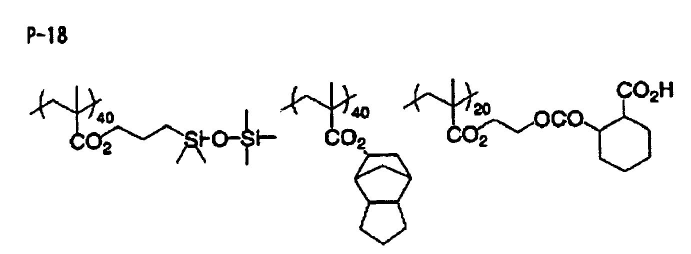 | 49,000 |
| 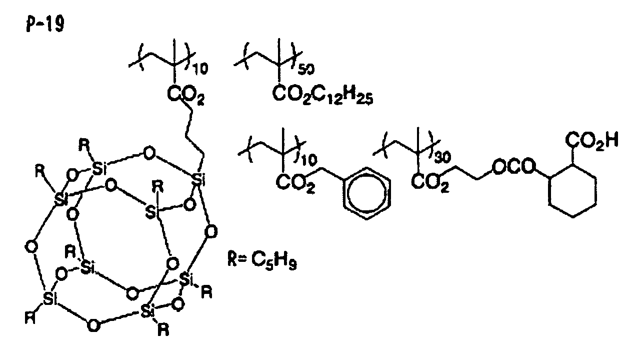 | 52,000 |
| 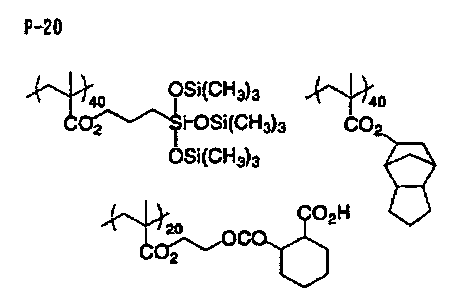 | 46,000 |
| 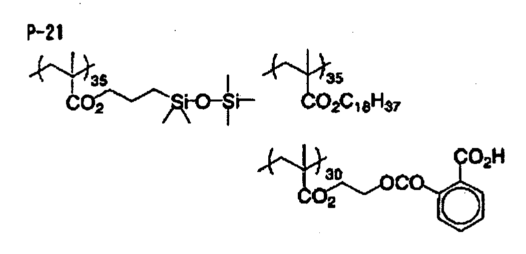 | 51,000 |
| 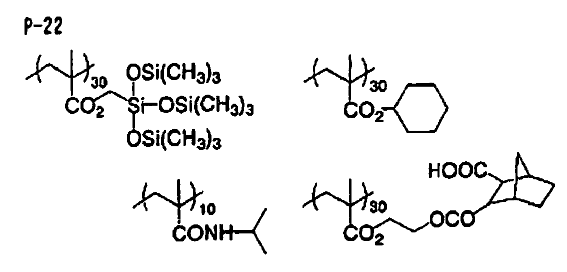 | 46,000 |
| 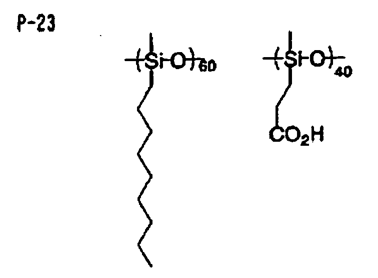 | 76,000 |
| 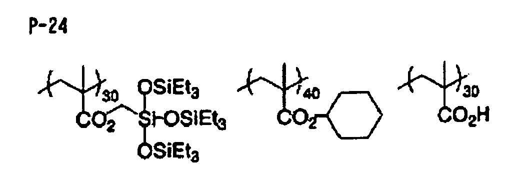 | 62,000 |
| 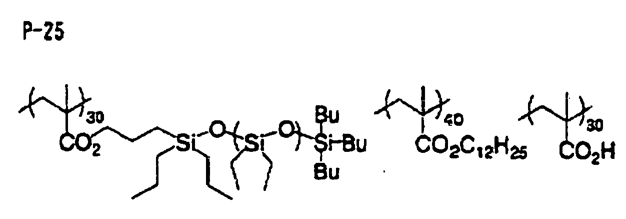 | 49,000 |
| 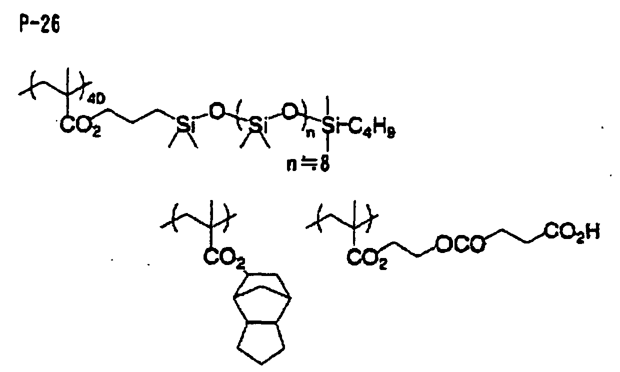 | 51,000 |
| 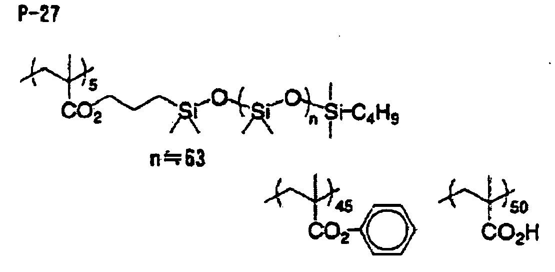 | 43,000 |

### [Infrared-light absorbing agent]

The recording layer of the planographic printing plate precursor of the present invention comprises an infrared-light absorbing agent (an infrared-light absorbing dye or pigment) having maximum absorbance at wavelengths in the range of 700 nm to 1200 nm.

The infrared-light absorbing agent has a function of absorbing the light energy irradiation radiation of infrared lasers and the like ,which are used for recording, to generate heat, and is therefore useful in view of improving recording sensitivity.

The dyes may be commercially available ones and known ones described in publications such as "Dye Handbook" (edited by the Society of Synthesis Organic Chemistry, Japan, and published in 1970). Specific examples thereof include azo dyes, metal complex azo dyes, pyrazolone azo dyes, naphthoquinone dyes, anthraquinone dyes, phthalocyanine dyes, carbonium dyes, quinoneimine dyes, methine dyes, cyanine dyes, squarylium dyes, pyrylium dyes, metal thiolate complexes, oxonol dyes, diimonium dyes, aminium dyes, and croconium dyes.

Preferable examples of the dye include cyanine dyes described in JP-A Nos. 58-125246, 59-84356, 59-202829, and 60-78787; methine dyes described in JP-A Nos. 58-173696, 58-181690, and 58-194595; naphthoquinone dyes described in JP-ANos. 58-112793, 58-224793, 59-48187, 59-73996, 60-52940, and 60-63744; squarylium dyes described in JP-A No. 58-112792; and cyanine dyes described in GB Patent No. 434,875.

Other preferable examples of the dye include near infrared absorbing sensitizers described in U.S. Patent No. 5,156,938; substituted arylbenzo(thio)pyrylium salts described in U.S. Patent No. 3,881,924; trimethinethiapyrylium salts described in JP-A No. 57-142645 (U.S. Patent No. 4,327,169); pyrylium type compounds described in JP-ANos. 58-181051, 58-220143, 59-41363, 59-84248, 59-84249, 59-146063, and 59-146061; cyanine dyes described in JP-ANo. 59-216146; pentamethinethiopyrylium salts described in U.S. Patent No. 4,283,475; and pyrylium compounds described in Japanese Patent Application Publication (JP-B) Nos. 5-13514 and 5-19702.

Additional preferable examples of the dye include near infrared absorbing dyes represented by formulae (I) and (II) as described in U.S. Patent No. 4,756,993.

Among these dyes, particularly preferable are cyanine dyes, phthalocyanine dyes, oxonol dyes, squarylium dyes, pyrylium salts, thiopyrylium dyes, and nickel thiolate complexes. Dyes represented by the following general formulae (a) to (e) are also preferable since such dyes are excellent in terms of photothermal conversion efficiency. The cyanine dyes represented by the following general formula (a) are most preferable for the following reason: when the dyes are used in the photosensitive composition of the invention, the dyes manifest a high degree of interaction with the alkali-soluble resin, and the dyes are also excellent in terms of stability and economy.

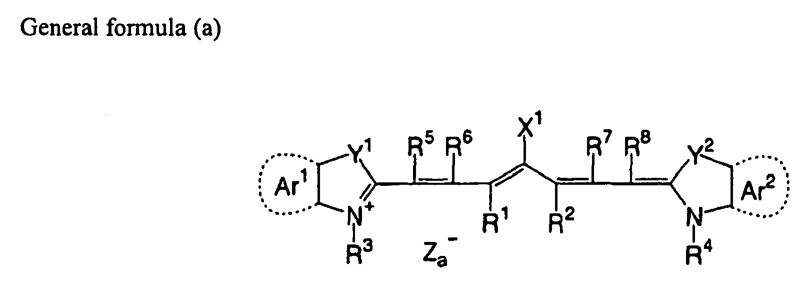

In general formula (a), X¹ represents a hydrogen atom, a halogen atom, -NPh₂, X²-L¹ (wherein X² represents an oxygen atom or a sulfur atom, L¹ represents a hydrocarbon group having 1 to 12 carbon atoms, an aromatic cyclic group having a heteroatom, or a hydrocarbon group containing a heteroatom and having 1 to 12 carbon atoms, and the heteroatom referred to herein is N, S, O, a halogen atom, or Se), or a group represented by the following: 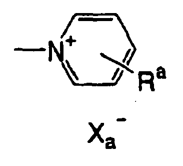 wherein
Xa⁻ has the same definition as Za⁻, which will be described at a later time, and R^{a} represents a substituent selected from a hydrogen atom, an alkyl group, an aryl group, a substituted or unsubstituted amino group, or a halogen atom;
R¹ and R² each independently represents a hydrocarbon group having 1 to 12 carbon atoms, and from the viewpoint of the storage stability of the photosensitive composition of the invention when it is used in a coating solution for forming a recording layer of a planographic printing plate precursor, it is preferable that R¹ and R² each independently represents a hydrocarbon group having 2 or more carbon atoms, and more preferably R¹ and R² are bonded to each other to form a 5-membered or 6-membered ring.
Ar¹ and Ar², which may be the same or different, each represent an aromatic hydrocarbon group which may have a substituent. Preferable examples of the aromatic hydrocarbon group include benzene and naphthalene rings. Preferable examples of the substituent include hydrocarbon groups having 12 or less carbon atoms, halogen atoms, and alkoxy groups having 12 or less carbon atoms.
Y¹ and Y², which may be the same or different, each represents a sulfur atom, or a dialkylmethylene group having 12 or less carbon atoms.
R³ and R⁴, which may be the same or different, each represents a hydrocarbon group which has 20 or less carbon atoms and may have a substituent. Preferable examples of the substituent include alkoxy groups having 12 or less carbon atoms, a carboxyl group, and a sulfo group. R⁵, R⁶, R⁷ and R⁸, which may be the same or different, each represents a hydrogen atom, or a hydrocarbon group having 12 or less carbon atoms, and since the raw materials thereof can easily be obtained, each preferably represents a hydrogen atom.
Za⁻ represents a counter anion. However, in a case where the cyanine dye represented by general formula (a) has an anionic substituent in the structure thereof and there is accordingly no need to neutralize electric charges in the dye, Za⁻ is not required. From the viewpoint of the storage stability of the recording layer coating solution, Za⁻ is preferably an ion of a halogen, perchlorate, tetrafluroborate, hexafluorophosphate, or sulfonate. Za⁻ is most preferably an ion of perchlorate, hexafluorophosphate, and arylsulfonic ion.

Specific examples of the cyanine dye represented by general formula (a), and which can be preferably used in the invention, include dyes in JP-A No. 2001-133969 (paragraphs [0017] to [0019]), JP-A No. 2002-40638 (paragraphs [0012] to [0038]), and JP-A No. 2002-23360 (paragraphs [0012] to [0023]), as well as dyes illustrated below.

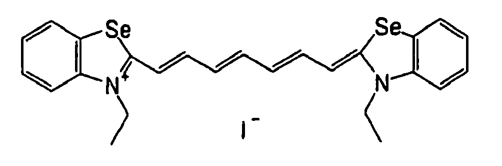

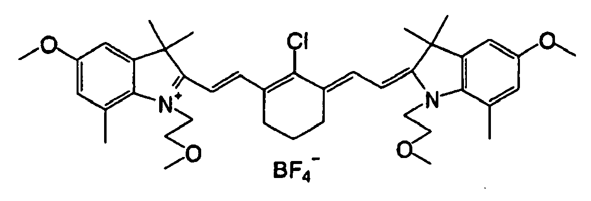

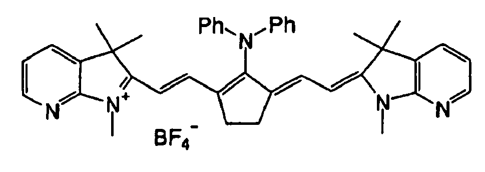

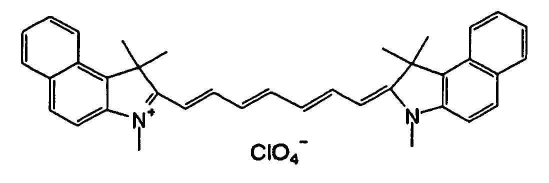

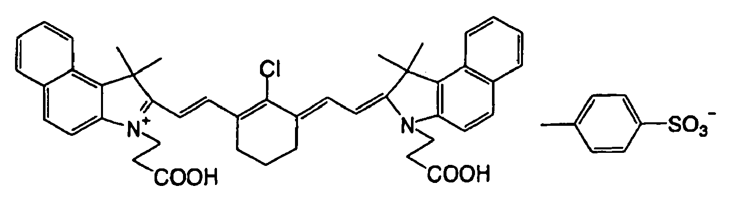

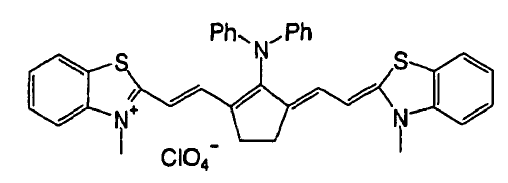

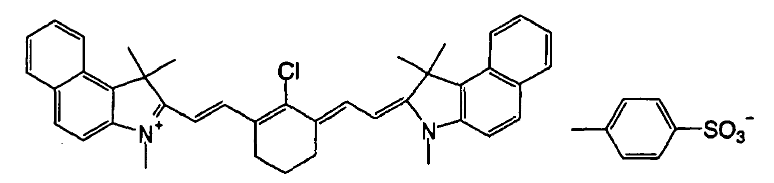

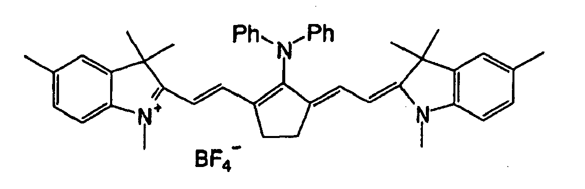

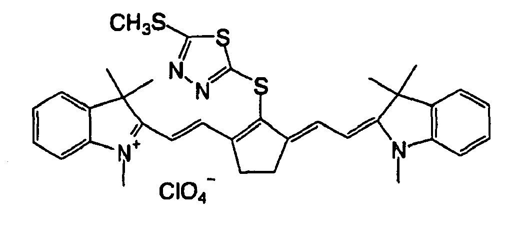

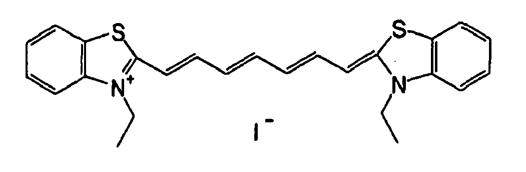

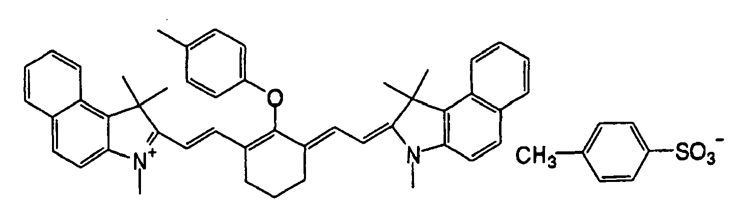

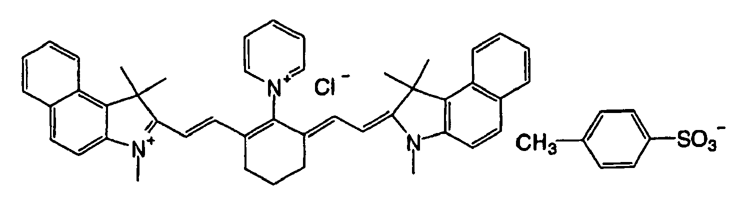

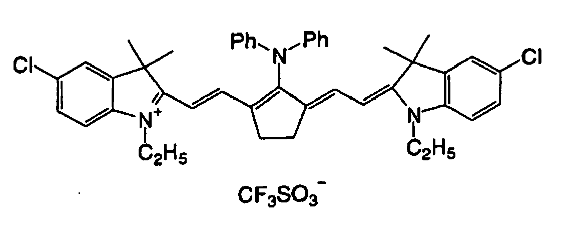

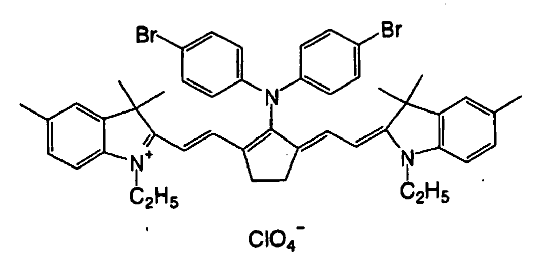

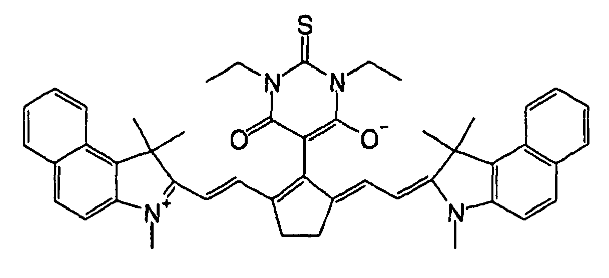

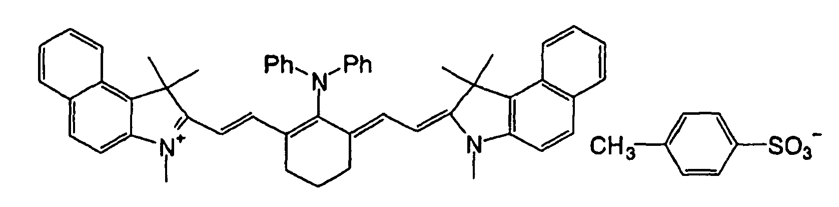

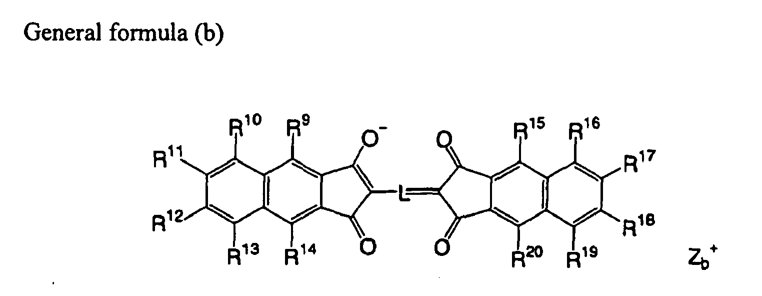

In general formula (b), L represents a methine chain having 7 or more conjugated carbon atoms, and the methine chain may have one or more substituent. The substituents may be bonded to each other to form a cyclic structure. Zb⁺ represents a counter cation. Preferable examples of the counter cation include ammonium, iodonium, sulfonium, phosphonium and pyridinium ions, and alkali metal cations (such as Ni⁺, K⁺ and Li⁺).

R⁹ to R¹⁴ and R¹⁵ to R²⁰ each independently represents a substituent selected from hydrogen atom, halogen atom, and cyano, alkyl, aryl, alkenyl, alkynyl, carbonyl, thio, sulfonyl, sulfinyl, oxy and amino groups; or a substituent obtained by combining two or three from among these substituents. Two or three out of R⁹ to R¹⁴ and R¹⁵ to R²⁰ may be bonded to each other to form a cyclic structure.

A dye wherein L in general formula (b) represents a methine chain having 7 conjugated carbon atoms, and each of R⁹ to R¹⁴ and R¹⁵ to R²⁰ represents a hydrogen atom, is preferable since such a dye can be easily obtained and exhibits advantageous effects.

Specific examples of the dye represented by general formula (b), and which can be preferably used in the invention, are illustrated below.

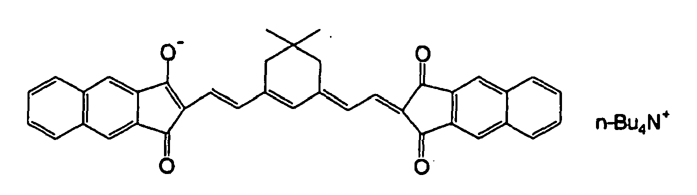

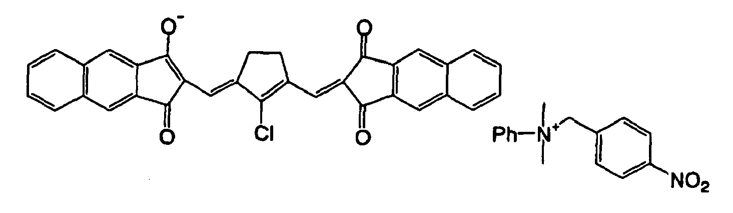

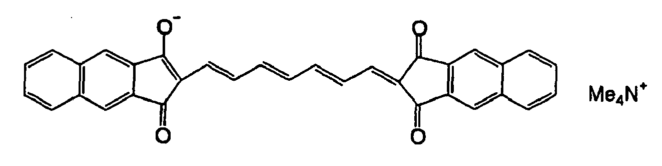

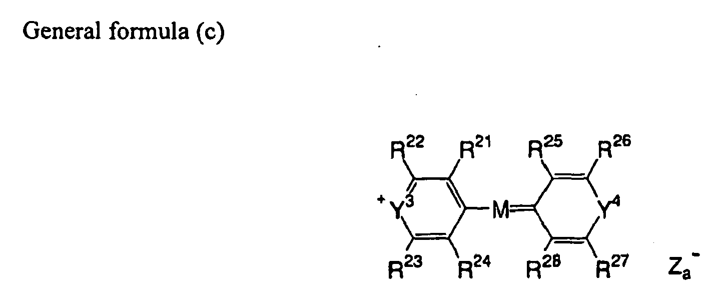

In general formula (c), Y³ and Y⁴ each independently represent an oxygen, sulfur, selenium or tellurium atom; M represents a methine chain having 5 or more conjugated carbon atoms; R²¹ to R²⁴ and R²⁵ to R²⁸, which may be the same or different, each represents a hydrogen or halogen atom, or a cyano, alkyl, aryl, alkenyl, alkynyl, carbonyl, thio, sulfonyl, sulfinyl, oxy or amino group; and Za⁻ represents a counter anion, and has the same meaning as Za⁻ in general formula (a).

Specific examples of the dye which is represented by general formula (c) and which can be preferably used in the invention, are illustrated below.

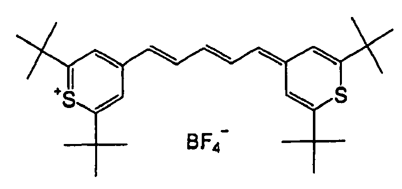

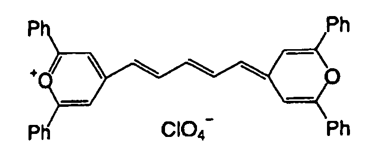

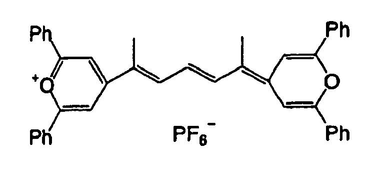

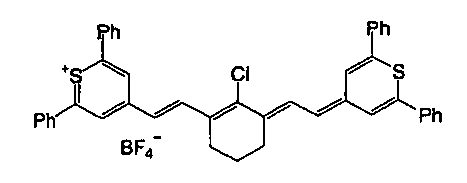

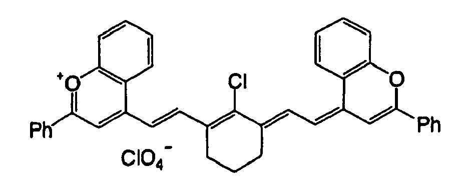

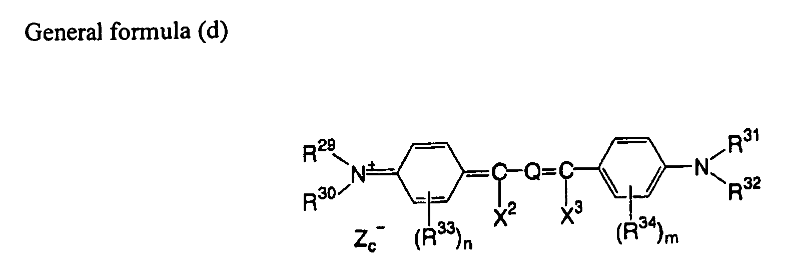

In general formula (d), R²⁹ to R³² each independently represents a hydrogen atom, an alkyl group or an aryl group; R³³ and R³⁴ each independently represents an alkyl group, a substituted oxy group, or a halogen atom; n and m each independently represents an integer of 0 to 4; and R²⁹ and R³⁰, or R³¹ and R³² may be bonded to each other to form a ring, or R²⁹ and/or R³⁰ may be bonded to R³³ to form a ring and R³¹ and/or R³² may be bonded to R³⁴ to form a ring. When plural R³³'s and R³⁴'s are present, R³³'s may be bonded to each other to form a ring, or R³⁴'s may be bonded to each other to form a ring.

X² and X³ each independently represents a hydrogen atom, an alkyl group or an aryl group, and at least one of X² and X³ represents a hydrogen atom or an alkyl group.

Q represents a trimethine group or a pentamethine group which may have a substituent, and may be combined with an bivalent linking group to form a cyclic structure. Zc⁻ represents a counter anion and has the same meanings as Za⁻ in general formula (a).

Specific examples of the dye represented by general formula (d) and which can be preferably used in the invention, are illustrated below.

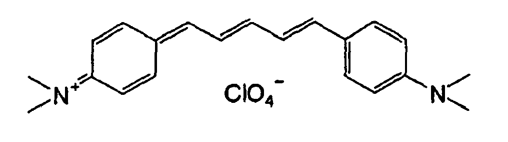

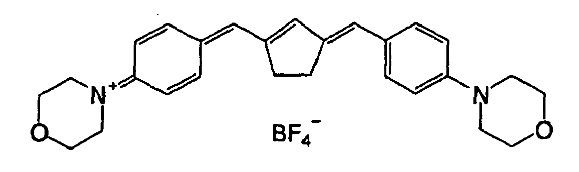

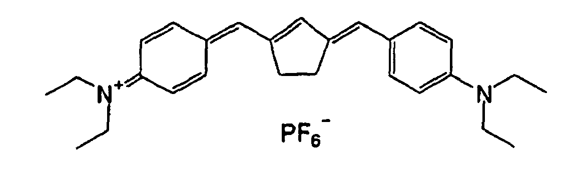

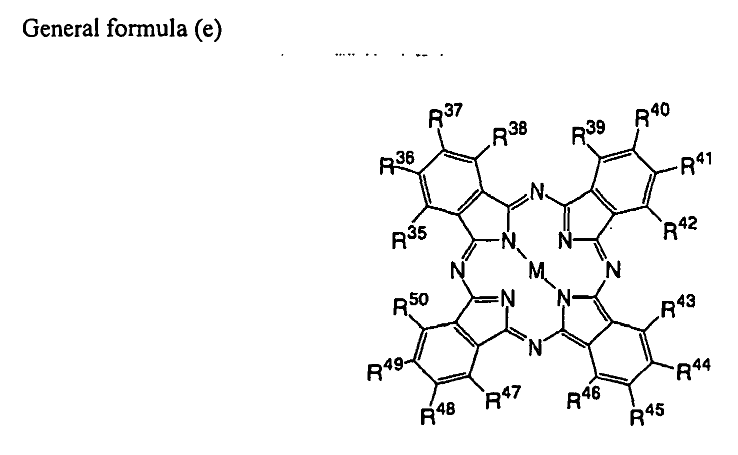

In general formula (e), R³⁵ to R⁵⁰ each independently represents a hydrogen or halogen atom, or a cyano, alkyl, aryl, alkenyl, alkynyl, hydroxyl, carbonyl, thio, sulfonyl, sulfinyl, oxy or amino group, or an onium salt structure, each of which may have a substituent; M represents two hydrogen atoms, a metal atom, a halo metal group, or an oxy metal group. Examples of the metal contained therein include atoms in IA, IIA, IIIB and IVB groups in the periodic table, transition metals in the first, second and third periods therein, and lanthanoid elements. Among these examples, preferable are copper, magnesium, iron, zinc, cobalt, aluminum, titanium, and vanadium.

Specific examples of the dye represented by general formula (e) and which can be preferably used in the invention, are illustrated below.

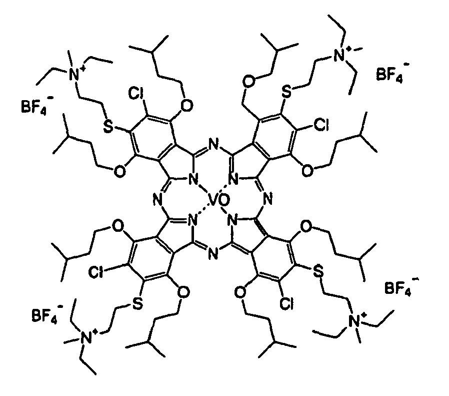

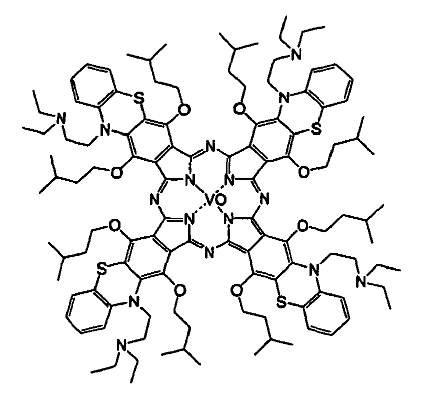

The pigment used as the infrared absorbent in the invention may be a commercially available pigment or a pigment described in publications such as Color Index (C.I.) Handbook, "Latest Pigment Handbook" (edited by Japan Pigment Technique Association, and published in 1977), "Latest Pigment Applied Technique" (by CMC Publishing Co., Ltd. in 1986), and "Printing Ink Technique" (by CMC Publishing Co., Ltd. in 1984).

Examples of the pigment include black pigments, yellow pigments, orange pigments, brown pigments, red pigments, purple pigments, blue pigments, green pigments, fluorescent pigments, metal powder pigments, and polymer-bonded dyes. Specifically, the following can be used: insoluble azo pigments, azo lake pigments, condensed azo pigments, chelate azo pigments, phthalocyanine pigments, anthraquinone pigments, perylene and perynone pigments, thioindigo pigments, quinacridone pigments, dioxazine pigments, isoindolinone pigments, quinophthalone pigments, dyeing lake pigments, azine pigments, nitroso pigments, nitro pigments, natural pigments, fluorescent pigments, inorganic pigments, and carbon black. Among these pigments, carbon black is preferable.

These pigments may be used with or without surface treatment. Examples of surface treatment include a method of coating the surface of the pigments with resin or wax; a method of adhering a surfactant onto the surface; and a method of bonding a reactive material (such as a silane coupling agent, an epoxy compound, or a polyisocyanate) to the pigment surface. The surface treatment methods are described in "Nature and Application of Metal Soap" (Saiwai Shobo), "Printing Ink Technique" (by CMC Publishing Co., Ltd. in 1984). And "Latest Pigment Applied Technique" (by CMC Publishing Co., Ltd. in 1986.

The particle size of the pigment is preferably from 0.01 to 10 µm, more preferably from 0.05 to I µm, and even more preferably from 0.1 to 1 µm. When a particle size is within the preferable range, a superior dispersion stability of the pigment in the photosensitive composition can be obtained, whereby, when the photosensitive composition of the invention is used for a recording layer of the photosensitive printing plate precursor, it is possible to form a homogeneous recording layer.

The method for dispersing the pigment may be a known dispersing technique used to produce ink or toner. Examples of a dispersing machine, which can be used, include an ultrasonic disperser, a sand mill, an attriter, a pearl mill, a super mill, a ball mill, an impeller, a disperser, a KD mill, a colloid mill, a dynatron, a three-roll mill, and a pressing kneader. Details are described in "Latest Pigment Applied Technique" (by CMC Publishing Co., Ltd. in 1986).

When these pigments or dyes are used in combination, a combination can be added at a percentage of 0.01 to 30 mass%, and preferably 0.1 to 10 mass% with respect to the total solid content which constitutes the recording layer in view of the balance between sensitivity and the uniformity and durability of the layerparticular. 0.1 to 5 mass% is prefereable in the case of a pigment, and 0.2 to 10 mass% is preferable in the case of a dye.

### [Water-insoluble alkali-soluble resin]

In the recording layer of the present invention, it is preferable to use a water-insoluble alkali-soluble resin (hereinafter, referred to as an "alkali-soluble resin" where appropriate) in view of improving the film coating property.

A alkali-soluble resin that can be used for a positive recording layer includes homopolymers comprising an acid group at the main chain and/or side chains in the polymer or copolymers thereof, or mixtures thereof.

Among these, alkali-soluble resins comprising any of the acid groups (1) to (6) listed in the explanation of the monomer having an alkali-soluble group for the particular polymer compound, those having an acid group in the main chain and/or side chains in the polymer are preferable, in view of solubility in an alkali developing solution and expression of the ability to suppress dissolution.

Among the alkali-soluble resin comprising the acidic group selected from the above-mentioned (1) to (6), an alkali-soluble resin comprising (1) phenol, (2) sulfone amide, or (3) active imido group is preferable and an alkali-soluble resin comprising (1) phenol or (2) sulfone amide is more preferable in terms of assurance of the sufficient solubility in an alkaline developer, development latitude, and film strength.

As the alkali-soluble resin comprising the acidic group selected from the above-mentioned (1) to (6), the following can be exemplified.
(1) Examples of the alkali-soluble resin comprising phenol group may include novolak resin such as condensation polymers of phenol and formaldehyde; condensation polymers of m-cresol and formaldehyde, condensation polymers of p-cresol and formaldehyde, condensation polymers of m-/p-mixed cresol and formaldehyde, and condensation polymers of phenol, cresol (m-, p-, or m-/p-mixture) and formaldehyde; and condensation copolymers of pyrogallol and acetone. Further, copolymers obtained by copolymerizing compound comprising phenyl groups in the side chains can be exemplified. Or, copolymers obtained by copolymerizing compounds comprising phenyl groups in the side chains can also be used.
   As the compounds comprising phenol group, acrylamide, methacrylamide, acrylic acid ester, methacrylic acid ester, or hydroxystyrene can be exemplified.
(2) Examples of the alkali-soluble resin comprising sulfoneamido group may include polymers obtained by using the minimum component units derived from compounds comprising sulfoneamido group as main constituent components. Examples of such compounds include those having at least one sulfoneamido group comprising at least one hydrogen atom bonded to the nitrogen atom and at least one polymerizable unsaturated group, in the molecules. Among them, low molecular weight compounds comprising acryloyl, allyl, or vinyloxy group as well as substituted or mono-substituted aminosulfonyl group or a substituted sulfonylimino group in molecules are preferable. Preferable examples the compounds include the compounds represented by the above-described general formulae (i) to (v) exemplified in the descriptions of the monomer having an alkali-soluble group.

Of the compounds represented by the represented by the general formulae (i) to (v), the following can preferably be used, in particular, in the planographic printing plate precursor of the present invention: m-aminosulfonylphenyl methacrylate, N-(p-aminosulfonylphenyl)methacrylamide and N-(p-aminosulfonylphenyl)acrylamide.

Examples of the alkali-soluble resin having an active imide group in the item (3) include polymers each having as the main constituent a minimum constituent unit derived from a compound having an acitive imide group. Examples of such a compound include compounds each having in the molecule thereof one or more active imide groups represented by the structural formula below and one or more unsaturated groups which can be polymerized with the active imide group(s):

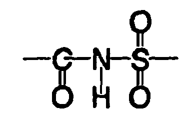

Specifically, N-(p-toluenesulfonyl)methacrylamide, N-(p-toluenesulfonyl)acrylamide and others can be preferably used.

Examples of the alkali-soluble resin having a carboxylic acid group in the item (4) include polymers each having as the main constituent a minimum constituent unit derived from a compound having in the molecule thereof one or more carboxylic acid groups and one or more unsaturated groups which can be polymerized with the carboxylic acid group(s).

Examples of the alkali-soluble polymer having a sulfonic acid group in the item (5) include polymers each having as the main constituent a minimum constituent unit derived from a compound having in the molecule thereof one or more sulfonic acid groups and one or more unsaturated groups which can be polymerized with the sulfonic acid group(s).

Examples of the alkali-soluble resin having a phosphoric acid group in the item (6) include polymers each having as the main constituent a minimum constituent unit derived from a compound having in the molecule thereof one or more phosphoric acid group and one or more unsaturated groups which can be polymerized with the phophoric acid group(s).

The minimum constituent unit comprising acidic group selected from (1) to (6) composing an alkali-soluble resin to be used for the positive-type recording layer of the invention is not necessarily limited to one particular unit, but those obtained by copolymerizing two or more types of minimum constituent units comprising the same acidic group or two or more types of minimum constituent units comprising different acidic groups can also be used.

The above-mentioned copolymer contains the compound having the acidic group selected from (1) to (6) to be copolymerized in an amount preferably 10% by mole or more, more preferably 20% by mole or more. If it is less than 10% by mole, the development latitude tends to be improved insufficiently.

In the invention, in the case the compounds are copolymerized to use the obtained copolymer as the alkali-soluble resin, the compounds to be copolymerized may include other compounds without acidic group (1) to (6). Examples of the compounds without acidic group (1) to (6) include the following compounds (m1) to (m12), however they should not be limited to these examples.
(m1) Acrylic acid esters and methacrylic acid esters having aliphatic hydroxyl groups such as 2-hydroxyethyl acrylate or 2-hydroxyethyl methacrylate.
(m2) Alkyl acrylate such as methyl acrylate, ethyl acrylate, propyl acrylate, butyl acrylate, amyl acrylate, hexyl acrylate, octyl acrylate, benzyl acrylate, 2-chloroethyl acrylate, and glycidyl acrylate.
(m3) Alkyl methacrylate such as methyl methacrylate, ethyl methacrylate, propyl methacrylate, butyl methacrylate, amyl methacrylate, hexyl methacrylate, cyclohexyl methacrylate, benzyl methacrylate, 2-chloroethyl methacrylate, and glycidyl methacrylate.
(m4) Acrylamide or methacrylamide such as acrylamide, methacrylamide, N-methylol acrylamide, N-ethylacrylamide, N-hexylmethacrylamide, N-cyclohexylacrylamide, N-hydroxyethylacrylamide, N-phenylacrylamide, N-nitrophenylacrylamide, and N-ethyl-N-phenylacxrylamide.
(m5) Vinyl ethers such as ethyl vinyl ether, 2-chloroethyl vinyl ether, hydroxyethyl vinyl ether, propyl vinyl ether, butyl vinyl ether, octyl vinyl ether, and phenyl vinyl ether.
(m6) Vinyl esters such as vinyl acetate, vinyl chloroacetate, vinyl butylate, and vinyl benzoate.
(m7) Styrenes such as styrene, α-methylstyrene, methylstyrene, and chloromethylstyrene.
(m8) Vinyl ketones such as methyl vinyl ketone, ethyl vinyl ketone, propyl vinyl ketone, and phenyl vinyl ketone.
(m9) Olefins such as ethylene, propylene, isobutylene, butadiene, and isoprene.
(m10) N-vinylpyrrolidone, acrylonitrile, and methacrylonitrile.
(m11) Unsaturated imides such as maleimide, N-acryloylacrylamide, N-acetylmethacrylamide, N-propionylmethacrylamide, and N-(p-chlorobenzoyl)methacrylamide.
(m12) Unsaturated carboxylic acid such as acrylic acid, methacrylic acid, maleic anhydride, and itaconic acid.

As the alkali-soluble resin, in terms of the excellent image formability by exposure by infrared laser, it is preferable to comprise phenolic hydroxyl groups and preferable examples of the resin to be usable are novolak resins and pyrogallol acetone resins such as phenol formaldehyde resin, m-cresol formaldehyde resin, p-cresol formaldehyde resin, m-/p-mixed cresol formaldehyde resin, and phenol/cresol (either m-, p- or m-/p-mixed) mixed formaldehyde resin.

Also, as the alkali-soluble resin having phenolic hydroxyl groups, condensed copolymers of phenol and formaldehyde comprising alkyl having 3 to 8 carbon atoms such as tert-butylphenol formaldehyde resin and octylphenol formaldehyde resin as a substituent group can be exemplified as described in US Patent No. 4,123,279.

The alkali-soluble resin has a weight average molecular weight preferably 500 or higher and more preferably 1,000 to 700,000 in terms of the image formability and has a number average molecular weight preferably 500 or higher and more preferably 700 to 650,000. The dispersion (the weight average molecular weight/the number average molecular weight) is preferably 1.1 to 10.

These alkali-soluble resins are used alone and two or more of them may be used in combination. In the case of combination, as described in US Patent No. 4, 123,279, condensed polymers of phenol comprising alkyl having 3 to 8 carbon atoms as a substituent group and formaldehyde such as condensed polymer of tert-butylphenol and formaldehyde, condensed polymer of octyl phenol and formaldehyde, and as described in Japanese Patent Application Laid-Open No. 2000-241972 previously applied by inventors, alkali-soluble resins having phenol structure having electron attractive group in an aromatic ring may be used in combination.

The alkali-soluble resin in the present invention has a total content of preferably 30 to 98 mass%, and more preferably 40 to 95 mass%, relative to the total solid content in the recording layer, in view of sensitivity, image-forming property and durability of the recording layer.

### [Other additives]

### (Dissolution suppressing agent)

In a positive-type recording layer relating to the invention, further, a substance which is thermally degradable and, in the not degraded state, substantially reduces solubility of an alkali-soluble resin, such as an onium salt, an o-quinonediazide compound, an aromatic sulfone compound and an aromatic sulfonic acid ester compound can be used together. Addition of these compounds is preferable from a viewpoint of improvement in dissolution suppressing ability of an image part in a developer.

Examples of an onium salt include a diazonium salt, an ammonium salt, a phosphonium salt, a iodonium salt, a sulfonium salt, a selenonium salt, and an arsonium salt. An onium salt is added preferably at 1 to 50% by mass, more preferably at 5 to 30% by mass, particularly preferably at 10 to 30% by mass relative to a total solid matter constituting an image recording material.

Further, for the purpose of improving sensitivity, cyclic acid anhydrides, phenols, and organic acids may be used.

A ratio of the cyclic acid anhydride, phenols and organic acids occupying in a recording layer is preferably 0.05 to 20% by mass, more preferably 0.1 to 15% by mass, particularly preferably 0.1 to 10% by mass.

In addition to them, an epoxy compound, vinyl ethers, a phenol compound having a hydroxymethyl group described in JP-A No. 8-276558, a phenol compound having an alkoxymethyl group, and a crosslinking compound having alkali dissolution suppressing action described in JP-A No. 11-160860 which has been previously proposed by the present inventors may be appropriately added depending on the purpose.

In addition, in order to widen stability of treatment on developing condition, a nonionic surfactant described in JP-A No. 62-251740 and JP-A No. 3-208514, and an amphoteric surfactant described in JP-A No. 59-121044 and 4-13149 may be added to a recording layer in the invention.

A sensitizing agent for obtaining a visible image immediately after heating by exposure, and a dye and a pigment as an image coloring agent may be added to a recording layer in the invention.

Further, if necessary, a plasticizer is added to a recording layer in the invention for imparting flexibility of a coated film. For example, oligomers and polymers of butylphthalyl, polyethylene glycol, tributyl citrate, diethyl phthalate, dibutyl phthalate, dihexyl phthalate, dioctylphthalate, tricresyl phosphate, tributyl phosphate, trioctyl phosphate, tetrahydrofurfuryl oleate, acrylic acid or methacrylic acid are used.

### [Preparation of planographic printing plate precursor]

A planographic printing plate precursor can be prepared by dissolving components for a coating solution of a desired layer, such as a recording layer coating solution and a protecting layer coating solution relating to the invention in a solvent, and coating the solution on a suitable support.

A recording layer may exhibit a monolayered structure or a multilayered structure.

When a recording layer of a planographic printing plate precursor of the present invention takes a multilayered structure consisting of a plurality of layers having different constitutional components, a construction may be adopted in which, for example, the layer has a lower layer containing an alkali-soluble resin, and an upper layer which contains an alkali-soluble resin, and a compound interacting with the alkali-soluble resin to reduce solubility in an aqueous alkali solution, and can form an image by irradiation with infrared-ray, and a particular infrared-ray absorbing agent is contained in at least one of the upper layer and the lower layer. In this case, a specific copolymer and an infrared-ray absorbing agent in the invention are contained in an upper layer. A lower limit may be a layer containing an alkali-soluble resin as a main component, or a layer which contains an infrared-ray absorbing agent or a dissolution suppressing agent, and functions as a positive-type recording layer.

The case where a recording layer relating to the invention takes a layered structure will be explained below.

### -Lower layer components-

A lower layer relating to the invention is characterized in that it contains an alkali-soluble resin. As an alkali-soluble resin used herein, the aforementioned general alkali-soluble resin may be used, but in order to make a boundary between an upper layer and a lower layer, it is preferable that an alkali-soluble resin used in a lower layer has a different main component from that of an alkali-soluble resin used in an upper layer. As an alkali-soluble resin suitably used in a lower layer, an alkali-soluble resin having a highly polar unit such as a copolymer of N-(p-aminosulfonylphenyl)(meth)acrylamide, (meth)acrylic acid alkyl ester and acrylonitrile, a copolymer of 4-maleimidebenzenesulfonamide and styrene, and a copolymer of (meth)acrylic acid, N-phenylmaleimide and (meth)acrylamide, or those resins in which the particular substituent is introduced are preferably used, but the invention is not limited to them.

From a viewpoint of printing durability and multilayered layer forming property, a content of a total alkali-soluble resin in a lower layer of such multilayered-type recording layer is preferably 50 to 100% by mass, more preferably 75 to 99% by mass, particularly preferably 85 to 95% by mass in a total solid matter of a lower layer recording layer.

A lower layer may or may not contain the aforementioned specific copolymer.

As a lower layer component relating to the invention, if necessary, other additive may be used. Examples of other additive include a developing promoter, a surfactant, a sensitizing agent/a coloring agent, a plasticizer, and WAX agent. Details of these components are as described above.

### -Upper layer components-

An upper layer relating to the invention is characterized in that it contains an alkali-soluble resin, and a compound which interacts with the alkali-soluble resin to reduce solubility in an aqueous alkali solution (generally, an infrared-ray absorbing pigment such as a cyanine pigment having that function), and can form an image by irradiation with infrared-ray. This upper layer component is the same as that explained as a recording layer previously and, in the invention, a recording layer containing the specific polymer compound and the infrared-ray absorbing agent is preferably used as an upper layer. Examples of a solvent used for coating a recording layer are not limited to, but include ethylene dichloride, cyclohexanone, methyl ethyl ketone, methanol, ethanol, propanol, ethylene glycol monomethyl ether, 1-methoxy-2-propanol, 2-methoxyethyl acetate, 1-methoxy-2-propyl acetate, dimethoxyethane, methyl lactate, ethyl lactate, N,N-dimethylacetamide, N,N-dimethylformamide, tetramethylurea, N-methylpyrrolidone, dimethylsulfoxide, sulfolane, γ-butyrolactone, toluene, and water. These solvents are used alone, or by mixing them.

A concentration of the above components (total solid matter including an additive) in a solvent is preferably 1 to 50% by mass.

As a coating method, various methods can be used. Examples include bar coater coating, rotation coating, spray coating, curtain coating, dipping coating, air knife coating, blade coating, and roll coating.

A surfactant for improving coating property, for example, a fluorine-based surfactant described in JP-A No. 62-170950 may be added to a recording layer coating solution relating to the invention. A preferable additional layer is 0.01 to 1% by mass, further preferably 0.05 to 0.5% by mass in terms of a solid matter in a recording layer.

In a multilayered-type recording layer, it is preferable that a lower layer and an upper layer are formed in principle to be separated two layers.

Examples of a method of formation of two separated layers include a method of utilizing a difference in solvent solubility between components contained in a lower layer, and components contained in an upper layer, and a method of coating an upper layer, and rapidly drying and removing a solvent.

These methods will be explained in detail below, and a method of coating two separated layers is not limited to them.

A method of utilizing a difference in solvent solubility between components contained in a lower layer and components contained in an upper layer is to use a solvent system in which all components contained in a lower layer are insoluble, when coating of a coating solution for an upper layer. Thereby, even when two layers are coated, it becomes possible to clearly separate each layer to make a coated film. For example, a component which is insoluble in a solvent such as methyl ethyl ketone and 1-methoxy-1-2-propanol which dissolves an alkali-soluble resin as an upper layer component is selected, a lower layer is coated and dried using a solvent system which dissolves the lower layer component and, thereafter, an upper layer component containing an alkali-soluble resin as a main component is dissolved in methyl ethyl ketone or 1-methoxy-2-propanol, thereby, it becomes possible to form two layers.

Then, examples of a method of drying a solvent extremely rapidly after coating of a second layer (upper layer) include a method of blowing a high pressure air through a slit nozzle disposed approximately vertical to a running direction of a web, a method of imparting heat energy as conducting heat from a lower surface of a web from a roll (heating roll) in which a heating medium such as steam has been supplied to an inside thereof, and a combination of those methods.

Alternatively, in order to impart new function, an upper layer and a lower layer are partially compatibilized actively in such a range that the effect of the invention is sufficiently exerted, in some cases. As such method, in any of the aforementioned method of utilizing difference in solvent solubility, and the method of drying a solvent extremely rapidly after coating of a second layer, this becomes possible by adjusting an extent thereof. A coating amount (solid matter) of a recording layer on a support obtained after coating and drying is different depending on utility and, as a coating amount grows smaller, apparent sensitivity is increased, but film property of a recording layer is reduced.

From a viewpoint of sensitivity and printing durability, a coating amount of recording layer components after drying in a monolayered-type recording layer is generally preferably in a range of 0.5 to 5.0 g/m², more preferably in a range of 0.7 to 4.0 g/m², further preferably in a range of 0.8 to 3.0 g/m².

From a viewpoint of sensitivity and printing durability, a coating amount of lower layer components after drying in a multilayered-type recording layer is preferably in a range of 0.5 to 4.0 g/m², further preferably in a range of 0.6 to 2.5 g/m². From a viewpoint of sensitivity, developing latitude and damage resistance, a coating amount of upper layer components after drying is preferably in a range of 0.05 to 1.0 g/m², further preferably in a range of 0.08 to 0.7 g/m².

From a viewpoint of sensitivity, image reproductivity, and printing durability, a coating amount of combined lower layer and upper layer after drying is preferably in a range of 0.6 to 4.0 g/m², further preferably in a range of 0.7 to 2.5 g/m².

### [Support]

The support which is used in the planographic printing plate precursors of the invention may be any plate-form product that has necessary strength and endurance and is dimensionally stable. Examples thereof include a paper sheet; a paper sheet on which a plastic (such as polyethylene, polypropylene, or polystyrene) is laminated; a metal plate (such as an aluminum, zinc, or copper plate), a plastic film (such as a cellulose diacetate, cellulose triacetate, cellulose propionate, cellulose lactate, cellulose acetate lactate, cellulose nitrate, polyethylene terephthalate, polyethylene, polystyrene, polypropylene, polycarbonate, or polyvinyl acetal film); and a paper or plastic film on which a metal as described above is laminated or vapor-deposited.

Of these supports, a polyester film or an aluminum plate is preferable in the invention. An aluminum plate is particularly preferable since the plate is good in dimensional stability and relatively inexpensive. Preferable examples of the aluminum plate include a pure aluminum plate, and alloy plates comprising aluminum as the main component and a small amount of different elements. A plastic film on which aluminum is laminated or vapor-deposited may be used. Examples of the different elements contained in the aluminum alloy include silicon, iron, manganese, copper, magnesium, chromium, zinc, bismuth, nickel, and titanium. The content by percentage of the different elements in the alloy is at most 10% by mass.

In the invention, pure aluminum is particularly preferable. However, completely pure aluminum is not easily produced from the viewpoint of metallurgy technology. Thus, aluminum containing a trance amount of the different elements may be used.

As described above, the aluminum plate used in the invention, the composition of which is not specified, may be any aluminum plate that has been known or used hitherto. The thickness of the aluminum plate used in the invention is generally from about 0.1 to 0.6 mm, preferably from 0.15 to 0.4 mm, and more preferably from 0.2 to 0.3 mm.

Such aluminum plate may be subjected to surface treatment such as surface roughening treatment and anode oxidation treatment if necessary. Such surface treatment will be briefly explained below.

Before the surface of the aluminum plate is roughened, the plate is subjected to degreasing treatment with a surfactant, an organic solvent, an aqueous alkaline solution or the like if desired, in order to remove rolling oil on the surface. The roughening treatment of the aluminum plate surface is performed by any one of various methods, for example, by a mechanically surface-roughening method, or a method of dissolving and roughening the surface electrochemically, or a method of dissolving the surface selectively in a chemical manner.

The mechanically surface-roughening method which can be used may be a known method, such as a ball polishing method, a brush polishing method, a blast polishing method or a buff polishing method. The electrochemically surface-roughening method may be a method of performing surface-roughening in a hydrochloric acid or nitric acid electrolyte by use of alternating current or direct current. As disclosed in JP-A No. 54-63902, a combination of the two may be used.

The aluminum plate the surface of which is roughened as described above is subjected to alkali-etching treatment and neutralizing treatment if necessary. Thereafter, the aluminum plate is subjected to anodizing treatment if desired, in order to improve the water holding ability or wear resistance of the surface. The electrolyte used in the anodizing treatment of the aluminum plate is any one selected from various electrolytes which can make a porous oxide film. There is generally used sulfuric acid, phosphoric acid, oxalic acid, chromic acid, or a mixed acid thereof. The concentration of the electrolyte may be appropriately decided dependently on the kind of the electrolyte.

Conditions for the anodizing treatment cannot be specified without reservation since the conditions vary dependently on the used electrolyte. The following conditions are generally suitable: an electrolyte concentration of 1 to 80% by mass, a solution temperature of 5 to 70°C, a current density of 5 to 60 A/dm², a voltage of 1 to 100 V, and an electrolyzing time of 10 seconds to 5 minutes. If the amount of the anodic oxide film is less than 1.0 g/m², the printing durability is insufficient or non-image areas of the planographic printing plate are easily injured so that the so-called "injury stains", resulting from ink adhering to injured portions at the time of printing, are easily generated.

If necessary, the aluminum surface is subjected to treatment for hydrophilicity after the anodizing treatment.

The treatment for hydrophilicity which can be used in the invention may be an alkali metal silicate (for example, aqueous sodium silicate solution) method, as disclosed in USP Nos. 2,714,066, 3,181,461, 3,280,734, and 3,902,734. In this method, the support is subjected to immersing treatment or electrolyzing treatment with aqueous sodium silicate solution. Besides, there may be used a method of treating the support with potassium fluorozirconate disclosed in JP-B No. 36-22063 or with polyvinyl phosphonic acid, as disclosed in USP Nos. 3,276,868, 4,153,461, and 4,689,272.

### (Undercoat layer)

In the planographic printing plate precursor of the invention, an undercoat layer may further be provided, as necessary, between the support and the recording layer.

As components for the undercoat layer, various organic compounds may be used. Examples thereof include carboxymethylcellulose, dextrin, gum arabic, phosphonic acids having an amino group such as 2-aminoethylphosphonic acid, organic phosphonic acids such as phenylphosphonic acid, naphthylphosphonic acid, alkylphosphonic acid, glycerophosphonic acid, methylenediphosphonic acid and ethylenediphosphonic acid, each of which may have a substituent, organic phosphoric acids such as phenylphosphoric acid, naphthylphosphoric acid, alkylphosphoric acid and glycerophosphoric acid, each of which may have a substituent, organic phosphinic acids such as phenylphosphinic acid, naphthylphosphinic acid, alkylphosphinic acid, and glycerophosphinic acid, each of which may have a substituent, amino acids such as glycine and β-alanine, and hydrochlorides of amines having a hydroxyl group, such as hydrochloride of triethanolamine. These may be used in a mixture form.

It is also preferable that an undercoating layer contains a compound having an onium group. A compound having an onium group is described in detail in JP-A No. 2000-10292 and 2000-108538. Besides, a compound selected from a group of polymer compounds having a structural unit, a representative of which is poly(p-vinyl benzoate), in a molecule may be used. More specifically, examples of the polymer compound include a copolymer of p-vinyl benzoate and a vinylbenzyltriethylammonium salt, and a copolymer of p-vinyl benzoate and vinylbenzyltrimethylammonium chloride.

This organic undercoat layer can be formed by the following method: a method of dissolving the above-mentioned organic compound into water, an organic solvent such as methanol, ethanol or methyl ethyl ketone, or a mixed solvent thereof to prepare a solution, applying the solution onto an aluminum plate, and drying the solution to form the undercoat layer; or a method of dissolving the above-mentioned organic compound into water, an organic solvent such as methanol, ethanol or methyl ethyl ketone, or a mixed solvent thereof to prepare a solution, dipping an aluminum plate into the solution to cause the plate to adsorb the organic compound, washing the plate with water or the like, and then drying the plate to form the undercoat layer.

In the former method, the solution of the organic compound having a concentration of 0.005 to 10% by mass can be applied by various methods. In the latter method, the concentration of the organic compound in the solution is from 0.01 to 20% by mass, preferably from 0.05 to 5% by mass, the dipping temperature is from 20 to 90°C, preferably from 25 to 50°C, and the dipping time is from 0.1 second to 20 minutes, preferably from 2 seconds to 1 minute.

The pH of the solution used in this method can be adjusted into the range of 1 to 12 with a basic material such as ammonia, triethylamine or potassium hydroxide, or an acidic material such as hydrochloric acid or phosphoric acid. A yellow dye can be added to the solution in order to improve the reproducibility of the tone of the image recording material.

The coated amount of the organic undercoat layer is suitably appropriately from 2 to 200 mg/m², and preferably from 5 to 100 mg/m², in terms of obtaining sufficient printing durability.

An image forming material thus formed is ordinarily subjected to image exposure and development process.

### (Back coating layer)

If necessary, a back coating layer is disposed on a support back of a planographic printing plate precursor of the invention. As such back coating layer, a covering layer consisting of an organic polymer compound described in JP-A No. 5-45885, and a metal oxide obtained by hydrolysis and polycondensation of an organic or inorganic metal compound described in JP-A No. 6-35174 is preferably used. Among these covering layers, an alkoxy compound of silicon such as Si(OCH₃)₄, Si(OC₂X₅)₄, Si(OC₃H₇)₄, and Si(OC₄H₉)₄ is inexpensive and easily available, and a covering layer of metal oxide derived therefrom is excellent in developer resistance, and is particularly preferable.

### [Exposure]

As a light source of active light used in image exposure of a planographic printing plate precursor of the invention, a light source having a light emitting wavelength in a near infrared to infrared region is preferable, and a solid laser, and a semiconductor laser are particularly preferable.

### [Developing treatment]

The developing solution which may be applied to the developing treatment of the planographic printing plate precursor of the invention is a developing solution having a pH range from 9.0 to 14.0 and preferably a pH range from 12.0 to 13.5. As the developing solution (hereinafter referred to as a developing solution including a replenishing solution), a conventionally known aqueous alkali solution may be used.

Examples of the alkali agent include inorganic alkali salts such as sodium silicate, potassium silicate, trisodium phosphate, tripotassium phosphate, triammonium phosphate, disodium hydrogenphosphate, dipotassium hydrogenphosphate, diammonium hydrogenphosphate, sodium carbonate, potassium carbonate, ammonium carbonate, sodium hydrogencarbonate, potassium hydrogencarbonate, ammonium hydrogen carbonate, sodium borate, potassium borate, ammonium borate, sodium hydroxide, ammonium hydroxide, potassium hydroxide and lithium hydroxide; and organic alkali agents such as monomethylamine, dimethylamine, trimethylamine, monoethylamine, diethylamine, triethylamine, monoisopropylamine, diisopropylamine, triisopropylamine, n-butylamine, monoethanolamine, diethanolamine, triethanolamine, monoisopropanolamine, diisopropanolamine, ethyleneimine, ethylenediamine, and pyridine. These alkali agents may be used alone or in combinations of two or more thereof.

Among the above aqueous alkali solutions, one developer which exerts the effect of the invention is an aqueous solution of a pH 12 or higher so-called "silicate developer" containing alkali silicate as a base, or containing alkali silicate obtained by mixing a base with a silicon compound, and the other more preferable developer is a so-called "non-silicate developer" which does not contain alkali silicate, and contains a non-reducing sugar (organic compound having buffering action) and a base.

In the former, developability of an aqueous solution of alkali metal silicate can be regulated by a ratio (generally expressed by mole ratio of [SiO₂]/[M₂O]) of silicon oxide SiO₂ and alkali metal oxide M₂O. For example, an aqueous solution of sodium silicate in which a mole ratio of SiO₂/Na₂O is 1.0 to 1.5 (that is,[SiO₂]/[Na₂O] is 1.0 to 1.5), and a content of SiO₂ is 1 to 4% by mass as disclosed in JP-A No. 54-62004, and an aqueous solution of alkali metal silicate in which [SiO₂]/[M] is 0.5 to 0.75 (that is, [SiO₂]/[M₂O] is 1.0 to 1.5), a concentration of SiO₂ is 1 to 4% by mass, and the developer contains at least 20% potassium using gram atom of a total alkali metal present therein as a standard, as described in Japanese Patent Application Publication (JP-B) No. 57-7427are preferably used.

A so-called "non-silicate developer" containing no alkali silicate and containing non-reducing sugar and a base is also preferable for application to developing of a planographic printing plate precursor of the invention. When a planographic printing plate precursor is developing-treated using this developer, a surface of a recording layer is not deteriorated, and inking property of a recording layer can be maintained in the letter state.

This developer contains, as its component, at least one compound selected from a non-reducing sugar, and a least one kind, a base, and it is preferable that a pH of the solution is in a range of 9.0 to 13.5. Such non-reducing sugar is a sugar having no free aldehyde group or ketone group, and not exhibiting reducing property, and is classified into a trehalose-type oligosaccharide in which reducing groups are bound, a glycoside in which a reducing group of a sugar and a non-sugar are bound, and sugar alcohol obtained by hydrogenating sugars to reduce them, and any of them is suitable used.

Examples of the trehalose type oligosaccharides include saccharose and trehalose. Examples of the glucosides include alkylglucosides, phenolglucosides, and mustard seed oil glucoside. Examples of the sugar alcohols include D, L-arabite, ribitol, xylitol, D, L-sorbitos, D, L-mannitol, D, L-iditol, D, L-talitol, dulcitol, and allodulcitol. Furthermore, maltitol, obtained by hydrogenating a disaccharide, and a reductant obtained by hydrogenating an oligosaccharide (i.e., reduced starch syrup) are preferable. Of these examples, sugar alcohol and saccharose are more preferable. D-sorbitol, saccharose, and reduced starch syrup are even more preferable since they have buffer effect within an appropriate pH range and are inexpensive.

These nonreducing sugars may be used alone or in combination of two or more thereof. The percentage thereof in the developer is preferably from 0.1 to 30% by mass, more preferably from 1 to 20% by mass from the viewpoints of the buffer effect and the developing power of the solution.

The base combined with the nonreducing sugar(s) may be an alkali agent that has been known so far. Examples thereof include inorganic alkali agents such as sodium hydroxide, potassium hydroxide, lithium hydroxide, trisodium phosphate, tripotassium phosphate, triammonium phosphate, disodium phosphate, dipotassium phosphate, diammonium phosphate, sodium carbonate, potassium carbonate, ammonium carbonate, sodium hydrogencarbonate, potassium hydrogencarbonate, ammonium hydrogencarbonate, sodium borate, potassium borate and ammonium borate; and organic alkali agents such as monomethylamine, dimethylamine, trimethylamine, monoethylamine, diethylamine, triethylamine, monoisopropylamine, diisopropylamine, triisopropylamine, n-butylamine, monoethanolamine, diethanolamine, triethanolamine, monoisopropanolamine, diisopropanolamine, ethyleneimine, ethylenediamine, and pyridine.

The bases may be used alone or in combination of two or more. Among the bases, sodium hydroxide and potassium hydroxide are preferable. The reason is that pH adjustment can be made in a wide pH range by regulating the amount of the alkali agent to be added to the non-reducing sugar. Also, trisodium phosphate, sodium carbonate, potassium carbonate or the like itself have a buffer action and are hence preferable.

These alkali agents are added so that a pH of the developer be in a range of 9.0 to 13.5. The amount depends on the desired pH and the type and additional amount of non-reducing sugar, and more preferable pH range is 10.0 to 13.2. In a developer, further, an alkaline buffer consisting of a weak acid and a strong base other than sugars can be used. As such weak acid used as a buffer, weak acids having a dissociation constant (pKa) of 10.0 to 13.2 are preferable.

Examples of such weak acid are selected from those described in IONISATION CONSTANTS OF ORGANIC ACIDS IN AQUEOUS SOLUTION published by Pergamin Press, and include alcohols such as 2,2,3,3-tetrafluoropropanol-1 (pKa 12.74), trifluoroethanol (pKa 12.37), trichloroethanol (pKa 12.24), aldehydes such as pyridine-2-aldehyde (pKa 12.68), and prydine-4-aldehyde (pKa 12.05), compounds having a phenolic hydroxyl group such as salicylic acid (pKa 13.0), 3-hydroxy-2-naphthoic acid (pKa 12.84), catechol (pKa 12.6), gallic acid (pKa 12.4), sulfosalicylic acid (pKa 11.7), 3,4-dihydroxysulfonic acid (pKa 12.2), 3,4-dihydroxybenzoic acid (pKa 11.94), 1,2,4-trihydroxybenzene (pKa 11.82), hydroquinone (pKa 11.56), pyrogallol (pKa 11.34), o-cresol (pKa 10.33), resorcinol (pKa 11.27), p-cresol (pKa 10.27), and m-cresol (pKa 10.09), oximes such as 2-buthanoneoxime (pKa 12.45), acetoxime (pKa 12.42), 1,2-cyclohectanedionedioxime (pKa 12.3), 2-hydroxybenzaldehydeoxime (pKa 12.10), dimethylglyoxime (pKa 11.9), ethanediamidodioxime (pKa 11.37), and acetophenoneoxime (pKa 11.35), nucleic acid-associated substances such as adenosine (pKa 12.56), inosine (pKa 12.5), guanine (pKa 12.3), cytosine (pKa 12.2), hypoxanthine (pKa 12.1), and xanthine (pKa 11.9), diethylaminomethylphosphonic acid (pKa 12.32), 1-amino-3,3,3-trifluorobenzoic acid (pKa 12.29), isopropylidenediphosphonic acid (pKa 12.10), 1,1-ethylidenediphosphonic acid (pKa 11.54), 1-hydroxy 1,1-ethylidenediphosphonate (pKa 11.52), benzimidazole (pKa 12.86), thiobenzamide (pKa 12.8), picolinethioamide (pKa 12.55), and barbituric acid (pKa 12.5).

Among these weak acids, preferable are sulfosalicylic acid, and salicylic acid. As a base to be combined with these weak acids, sodium hydroxide, ammonium hydroxide, potassium hydroxide, and lithium hydroxide are preferably used. These alkali agents are used alone, or by combining two or more kinds. The above various alkali agents are used by adjusting a pH in a preferable range by a concentration and a combination.

If necessary, various surfactants and organic solvents may be added to a developer in order to enhance promotion of developability, dispersing of a developing work-up and inkphilicity at a printing plate image part. Examples of a preferable surfactant include anionic, cationic, nonionic and amphoteric surfactants.

Preferable examples of surfactants include nonionic surfactants such as polyoxyethylene alkyl ethers, polyoxyethylene alkyl phenyl ethers, polyoxyethylene polystyryl phenyl ethers, polyoxyethylene polyoxypropylene alkyl ethers, glycerin fatty acid partial esters, sorbitan fatty acid partial esters, pentaerythritol fatty acid partial esters, propylene glycol monofatty acid esters, sucrose fatty acid partial esters, polyoxyethylene sorbitan fatty acid partial esters, polyoxyethylene sorbitol fatty acid partial esters, polyethylene glycol fatty acid esters, polyglycerin fatty acid partial esters, polyoxyethylenated castor oils, polyoxyethylene glycerin fatty acid partial esters, fatty acid diethanolamides, N,N-bis-2-hydroxyalkylamines, polyoxyethylenealkylamine, triethanolamine fatty acid ester, and trialkylamine oxide, anionic surfactants such as fatty acid salts, abietic acid salts, hydroxyalkanesulfonic acid salts, alkanesulfonic acid salts, dialkylsulfosuccinic acid ester salts, straight alkylbenzenesulfonic acid salts, branched alkylbenzenesulfonic acid salts, alkylnaphthalenesulfonic acid salts, alkylphenoxypolyoxyethylene propyl sulfonic acid salts, polyoxyethylene alkylsulfophenyl ether salts, N-methyl-N-oleyl taurine sodium salt, N-alkylsulfosuccinic acid monoamide disodium salt, petroleum sulfonic acid salts, sulfated tallow soil, fatty acid alkyl ester sulfuric acid ester salts, alkyl sulfate ester salts, polyoxyethylene alkyl ether sulfate ester salts, fatty acid monoglyceride sulfate ester salts, polyoxyethylene alkyl phenyl ether sulfate ester salts, polyoxyethylene styryl phenyl ether sulfate ester salts, alkyl phosphate ester salts, polyoxyethylene akyl etser phosphate ester salts, polyoxyethylene alkyl phenyl ether phosphate ester salts, partially saponified styrene/maleic acid anhydride copolymer, partially saponified olefin/maleic acid copolymer, and naphthalene sulfonic acid salt formalin condensates, cationic surfactants such as alkylamine salts, quaternary ammonium salts such as tetrabutyl ammonium bromide, polyoxyethylene alkylamide salts, and polyethylene polyamine derivative, and amphoteric surfactants such as carboxybetaines, aminocarboxylic acids, sulfobetaines, amino sulfate esters, and imidazolines. Polyoxyethylene referred in the above surfactants can be exchangeably read into polyoxyalkylene such as polyoxymethylene, polyoxypropylene, and polyoxybutylene, and those surfactants are also included.

A further preferable surfactant is a fluorine-based surfactant containing a perfluoroalkyl group in a molecule. Examples of such fluorine-based surfactant include anionic type such as perfluoroalkylcarboxylic acid salt, perfluoroalkylsulfonic acid salt, and perfluoroalkylphosphoric acid ester, amphoteric type such as perfluoroalkylbetaine, cationic type such as perfluoroalkyltrimethylammonium salt, and nonionic type such as perfluoroalkylamine oxide, perfluoroalkylethylene oxide adduct, perfluoroalkyl group and hydrophilic group-containing oligomer, perfluoroalkyl group and lipophilic group-containing oligomer perfluoroalkyl group, hydrophilic group and lipophilic group-containing oligomer, and perfluoroalkyl group and lipophilic group-containing urethane. The above surfactants may be used alone, or by combining two or more kinds, and are added to a developer in a range of 0.001 to 10% by mass, more preferably 0.01 to 5% by mass.

In a developer, various developing stabilizing agents can be used. Preferable examples of them include a polyethylene glycol adduct of sugar alcohol, a tetraalkylamonium salt such as tetrabutylammonium hydroxide, a phosphonium salt such as tetrabutylphosphonium bromide, and a iodonium salt such as diphenyliodonium chloride described in JP-A No. 6-282079. Further examples include an anionic surfactant and an amphoteric surfactant described in JP-A No. 50-51324, a water-soluble cationic polymer described in JP-A No. 55-95946, and a water-soluble amphoteric polymer electrolyte described in JP-ANo. 56-142528.

Further examples include an organic boron compound with alkylene glycol added thereto described in JP-A No. 59-84241, a polyoxyethylene polyoxypropylene block polymerization-type water-soluble surfactant described in JP-A No. 60-111246, an alkylenediamine compound in which polyoxyethylene · polyoxypropylene is substituted described in JP-A No. 60-129750, polyethylene glycol having a weight average molecular weight of 300 or more described in JP-ANo. 61-215554, a fluorine-containing surfactant having a cationic group described in JP-ANo. 63-175858, and a water-soluble ethylene oxide-added compound, and a water-soluble polyalkylene compound obtained by adding 4 more or more of ethylene oxide to an acid or an alcohol described in JP-A No. 2-39157.

An organic solvent is added to a developer if necessary. As the organic solvent, an organic solvent having solubility in water of about 10% by mass or less is suitable, and preferably an organic solvent is selected from organic solvents having solubility in water of 5% by mass or less. Examples include 1-phenylethanol, 2-phenylethanol, 3-phenyl-1-propanol, 4-phenyl-1-butanol, 4-phenyl-2-butanol, 2-phenyl-1-butanol, 2-phenoxyethanol, 2-benzyloxyethanol, o-methoxybenzyl alcohol, m-methoxybenzyl alcohol, p-methoxybenzyl alcohol, benzyl alcohol, cyclohexanol, 2-methylcyclohexanol, 3-methylcyclohexanol, 4-methylcyclohexanol, N-phenylethanolamine, and N-phenyldiethanolamine.

A content of an organic solvent is 0.1 to 5% by mass relative to a total mass of a solution used. A use amount thereof is closely related with a use amount of a surfactant. It is preferable that as an amount of an organic solvent is increased, an amount of a surfactant is increased. This is because when an amount of surfactant is small, and a large amount of an organic solvent is used, an organic solvent is not completely dissolved, therefore, maintenance of better developability can not be expected.

A reducing agent can be further added to a developer. This prevents stain of a printing plate. Examples of a preferable organic reducing agent include a phenol compound such as thiosalicylic acid, hydroquinone, methol, methoxyquinone, resorcine, and 2-methylresorcine, and an amine compound such as phenylenediamine, and phenylhydrazine. Examples of a further preferable inorganic reducing agent include a sodium salt, a potassium salt, and an ammonium salt of an inorganic acid such as sulfurous acid, hydrogen sulfurous acid, phosphorous acid, hydrogen phosphorous acid, dihydrogen phosphorous acid, thiosulfuric acid and dithionic acid.

Among these reducing agents, a reducing agent particularly excellent in stain preventing effect is a sulfite salt. These reducing agents are contained in a developer upon use preferably in a range of 0.05 to 5% by mass.

Organic carboxylic acid may further added to a developer. Preferable organic carboxylic acid is aliphatic carboxylic acid and aromatic carboxylic acid having 6 to 20 carbon atoms. Specific examples of aliphatic carboxylic acid include caproic acid, enathylic acid, caprylic acid, lauric acid, myristic acid, palmitic acid and stearic acid, and particularly preferable is alkanoic acid having 8 to 12 carbon atoms. Carboxylic acid may be an unsaturated fatty acid having a double bond in a carbon chain, or a branched carbon chain. Aromatic carboxylic acid is a compound in which benzene ring, a naphthalene ring, or an anthracene ring is substituted with a carboxylic group, and examples include o-chlorobenzoic acid, p-chlorobenzoic acid, o-hydoxybenzoic acid, p-hydroxybenzoic acid, o-aminobenzoic acid, p-aminobenzoic acid, 2,4-dyhydroxybenzoic acid, 2,5-dihydroxybenzoic acid, 2,6-dihdroxybenzoic acid, 2,3-dihydroxybenzoic acid, 3,5-dihydroxybenzoic acid, gallic acid, 1-hydroxy-2-naphthoic acid 3-hydroxy-2-naphthoic acid, 2-hydroxy-1-naphthoic acid, 1-naphthoic acid, and 2-naphthoic acid. Hydroxynaphthoic acid is particularly effective.

It is preferable to use the aforementioned aliphatic or aromatic carboxylic acid as a sodium salt, a potassium salt or an ammonium salt in order to enhance water solubility. A content of organic carboxylic acid in a developer used in the invention is not particularly limited. When the content is less than 0.1 % by mass, the effect is not sufficient and, when the content is 10% or more, not only the effect is not improved more, but also this prevents dissolution upon use of another additive. Therefore, a preferable addition amount is 0.1 to 10% by mass, more preferably 0.5 to 4% by mass relative to a developer.

If necessary, a developer may further contain an antiseptic, a coloring agent, a thickener, an anti-foaming agent and hard water softening agent. Examples of a hard water softening agent include polyphosphoric acid and a sodium salt, a potassium salt and an ammonium salt thereof, aminopolycarboxylic acid such as ethylenediaminetetraacetic acid, diethylenetriaminepentaacetic acid, triethylenetetraminehexaacetic acid, hydroxyethylethylenediaminetriacetic acid, nitrilotriacetic acid, 1,2-diaminocyclohexanetetraacetic acid, and 1,3-diamino-2-propanoltetraacetic acid, and a sodium salt, a potassium salt and an ammonium salt thereof, aminotri(methylenephosphonic acid), ethylenediaminetetra(methylenephosphonic acid), diethylenetriaminepenta(methylenephosphonic acid), triethylenetetraminehexa(methylenephosphonic acid), hydroxyethylethylenediaminetri(methylenephosphonic acid) and 1-hydroethane-1,1-diphosphonic acid, and a sodium salt, a potassium salt and an ammonium salt thereof.

An optimal value of such hard water softening agent varies depending on chelating thereof, and a hardness of hard water to be used, and an amount of hard water. A general use amount is in a range of 0.01 to 5% by mass, more preferably 0.01 to 0.5% by mass relative to a developer upon use. When an addition amount is smaller than this range, desired purpose is not sufficiently attained and, when an addition amount is larger than this range, this adversely influences on an image part, such as decoloration. A remaining component of a developer is water. It is advantageous from a viewpoint of transportation that a developer is formulated into a concentrated solution having a smaller content of water than that at use, and the solution is diluted with water upon use. A concentration degree in this case is suitably such an extent that each component is not separated or precipitated.

As a developer to be used in the invention, the developer described in JP-A No. 6-282079 can be also used. This is a developer containing an alkali metal silicate salt having a mole ratio of SiO₂/M₂O (M represents an alkali metal) of 0.5 to 2.0, and a water-soluble ethylene oxide-added compound obtained by adding 5 mole or more of ethylene oxide to sugar alcohol having 4 or more of hydroxyl groups. Sugar alcohol is a polyhydric alcohol corresponding to an entity in which an aldehyde group or a ketone group of a sugar is reduced to a primary or secondary alcohol group. Examples of sugar alcohol include D, L-D, L-threit, erythrit, D, L-aribit, ribit, xilit, D, L-sorbit, D, L-mannit, D, L-igit, D, L-talit, dulcit, and allodulcit. Further examples include di-, tri-, tetra-, penta- and hexaglycerin which are fused with sugar alcohol. The water-soluble ethylene oxide-added compound is obtained by adding 5 mole or more of ethylene oxide to 1 mole of the sugar alcohol. Further, if necessary, propylene oxide may be block-copolymerized with an ethylene oxide-added compound in such a range that solubility is acceptable. These ethylene oxide-added compounds may be used alone, or by combining two or more kinds.

An addition amount of these water-soluble ethylene oxide-added compounds is suitably 0.001 to 5% by mass, more preferably 0.001 to 2% by mass relative to a developer (use solution).

The aforementioned various surfactants and organic solvents may be further added to this developer, if necessary, for the purpose of enhancing promotion of developability, dispersing of developing work-up, and inkphilicity at a printing plate image part.

A planographic printing plate precursor which has been developing-treated with a developer having such composition is post-treated with washing water, a rinse solution containing a surfactant, or a finisher or a protecting gum solution containing, as a main component, gum arabic or a starch derivative. For post-treatment of the planographic printing plate precursor of the invention, these treatments can be used by variously combining them.

In recent years, automatic developing machines for printing plate precursors have been widely used in order to rationalize and standardize plate-making processes in the plate-making and printing industries. These automatic developing machines are generally made up of a developing section and a post-processing section. Specifically, the machine includes a device for carrying printing plate precursors, various treating solution tanks, and spray devices. These machines are machines for spraying respective treating solutions, which are pumped up, onto an exposed printing plate through spray nozzles, for development, while the printing plate is transported horizontally.

Recently, a method has also attracted attention in which a printing plate precursor is immersed in treating solution tanks filled with treating solutions and conveyed by means of in-liquid guide rolls, to effect development. Further, there has been known a method in which rinsing is carried out with a small predetermined amount of rinsing water supplied onto the printing plate after development and the waste water is re-used as the diluting water for the original developer.

Such automatic processing can be performed while replenishers are being replenished into the respective treating solutions in accordance with the amounts to be treated, operating times, and other factors. Further, a so-called use-and-dispose processing manner can also be used, in which treatments are conducted with treating solutions which in practice have not yet been used.

In the planographic printing plate precursor of the present invention, in cases where unnecessary image portions (for example, a film edge mark of an original picture film) are present on a planographic printing plate obtained by exposing imagewise a planographic printing plate precursor to which the invention is applied, developing the exposed precursor, and subjecting the developed precursor to water-washing and/or rinsing and/or desensitizing treatment(s), unnecessary image portions can be erased.

The erasing is preferably performed by applying an erasing solution to unnecessary image portions, leaving the printing plate as it is for a given time, and washing the plate with water, as described in, for example, JP-B No. 2-13293. This erasing may also be performed by a method of radiating active rays introduced through an optical fiber onto the unnecessary image portions, and then developing the plate, as described in JP-A No. 59-174842.

The planographic printing plate obtained as described above is, if desired, coated with a desensitizing gum, and subsequently the plate can be made available for a printing step. When it is desired to make a planographic printing plate have a higher degree of printing resistance, baking treatment is applied to the planographic printing plate.

In a case where the planographic printing plate is subjected to the baking treatment, it is preferable that before the baking treatment takes place the plate is treated with a surface-adjusting solution as described in JP-B No. 61-2518, or JP-A Nos. 55-28062, 62-31859 or 61-159655.

This method of treatment is, for example, a method of applying the surface-adjusting solution onto the planographic printing plate with a sponge or absorbent cotton infiltrated with the solution, a method of immersing the planographic printing plate in a vat filled with the surface-adjusting solution, or a method of applying the surface-adjusting solution to the planographic printing plate with an automatic coater. In a case where after application the amount of solution applied is made uniform with a squeegee or a squeegee roller, a better result can be obtained.

In general, the amount of surface-adjusting solution applied is suitably from 0.03 to 0.8 g/m² (dry mass). If necessary the planographic printing plate onto which the surface-adjusting solution is applied can be dried, and then the plate is heated to a high temperature by means of a baking processor (for example, a baking processor (BP-1300) sold by Fuji Photo Film Co., Ltd.) or the like. In this case the heating temperature and the heating time, which depend on the kind of components forming the image, are preferably from 180 to 300°C and from 1 to 20 minutes, respectively.

If necessary, a planographic printing plate subjected to baking treatment can be subjected to treatments which have been conventionally conducted, such as a water-washing treatment and gum coating. However, in a case where a surface-adjusting solution containing a water soluble polymer compound or the like is used, the so-called desensitizing treatment (for example, gum coating) can be omitted. The planographic printing plate obtained as a result of such treatments is applied to an offset printing machine or to some other printing machine, and is used for printing on a great number of sheets.

### EXAMPLES

Hereinafter, examples are described, and the present invention is specifically explained with reference thereto, but the present invention is not limited to these examples.

### <Synthesis of particular polymer compounds and polymer compounds for comparison>

### [Synthesis Example 1: particular polymer compound (P-1)]

A solution of a monomer in which terminals of polydimethylsiloxane have been modified with methacryloxypropyl groups (trade name: MCR-M11, manufactured by Gelest) 0.2 mol, methacrylic acid (manufactured by Tokyo Kasei Kogyo Ltd.) 0.8 mol, and 2,2'-azobis(2-methylbutyronitrile) (manufactured by Wako Pure Chemical Ltd.) 0.01 mol was delivered in drops to a 150 g. solution of 1-methoxy-2-propanol maintained at 85° C. for 6 hours under a nitrogen stream. After the delivery was completed, the solution was stirred for a further 5 hours at 85°C to give a particular polymer compound (P-1). The weight-average molecular weight of the particular polymer compound (P-1) was measured by gel permeation chromatography and was determined to be 35,000 by polystyrene conversion. Furthermore, the structure of the particular polymer compound (P-1) thus obtained was identified by its NMR (nuclear magnetic resonance) and IR (infrared) spectra.

### [Synthesis Example 2: particular polymer compound (P-7)]

A solution of a monomer in which terminals of polydimethylsiloxane have been modified with methacryloxypropyl groups (trade name: MCR-M11, manufactured by Gelest) 0.3 mol, FA-513A (trade name, manufactured by Hitachi Chemical Co., Ltd.) 0.3 mol, and HO-HH (trade name, manufactured by Kyoeisha Chemical Co., Ltd.) 0.4 mol, and 2,2'-azobis(2-methylbutyronitrile) (manufactured by Wako Pure Chemical Ltd.) 0.01 mol in a 1-methoxy-2-propanol (150 g) solution was delivered in drops to a 150 g. solution of 1-methoxy-2-propanol maintained at 85°C for 6 hours under a nitrogen stream. After the delivery was completed, the solution was stirred for a further 5 hours at 85°C to give a particular polymer compound (P-7). The weight-average molecular weight of the particular polymer compound (P-7) was measured by gel permeation chromatography and was determined to be 52,000 by polystyrene conversion. Furthermore, the structure of the particular polymer compound (P-7) thus obtained was identified by its NMR and IR spectra.

In a similar manner, the particular polymer compounds (P-2) to (P-6) and (P-8) to (P-26), and the polymer compounds for comparison (AP-1) to (AP-7) were obtained. The structures of these particular polymer compounds are as mentioned above. In addition, the structures of the polymer compounds for comparison (AP-1) to (AP-7) and their weight-average molecular weight (Mw) are shown below.

| | Mw |
|---|---|
| 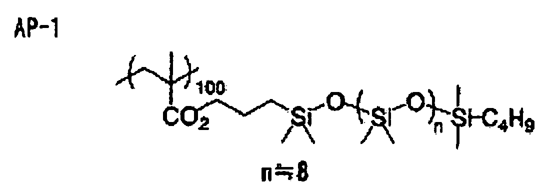 | 39,000 |
| 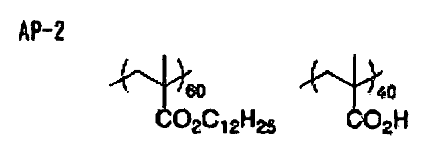 | 51,000 |
| 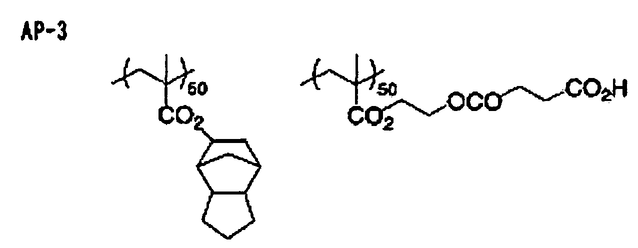 | 61,000 |
| 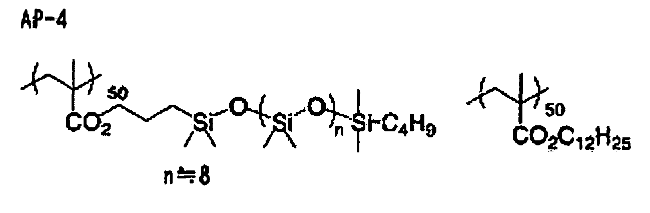 | 37,000 |
| 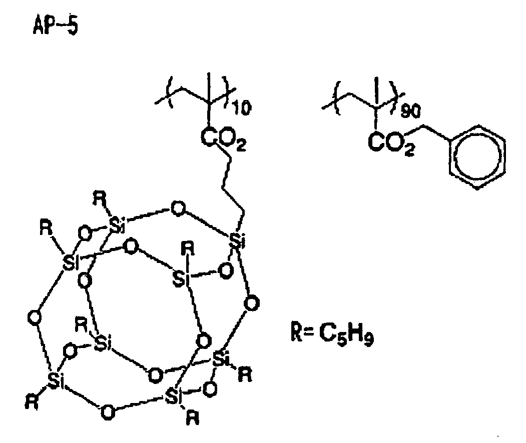 | 46,000 |
| 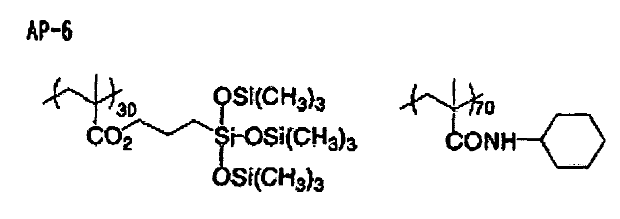 | 48,000 |
| 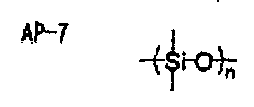 | 71,000 |

### [Examples 1 to 10, Comparative Examples 1 to 4]

### (Preparation of support)

Using a JIS-A-1050 aluminum plate having a thickness of 0.3 mm, the aluminum plate was treated by combining the following steps to prepare supports A, B, C and D.

### (a) Mechanical surface roughening treatment

While a suspension containing a polishing agent (silica sand) with a specific gravity of 1.12 and water was supplied as a polishing slurry to the a surface of each aluminum sheet, the and mechanical surface roughening was carried out by rotating roller type nylon brushes. The average particle size of the polishing agent was 8 µm and the maximum particle size was 50 µm. The material of the nylon brushes was 6-10 nylon and hair length and hair diameters were 45 mm and 0.3 mm, respectively. The nylon brushes were produced by implanting the hairs densely in holes formed in stainless cylinders with a diameter of φ300 mm. Three rotating brushes were used. Two supporting rollers (φ200 mm diameter) were placed in lower parts of the brushes with a separation distance of 300 mm. The brush rollers were pushed until the load of the driving motor for rotating the brushes was increased by 7 kW or more from the load before the brush rollers being pushed against the aluminum sheet. The rotation direction of the brushes was the same as the moving direction of the aluminum sheet. The rotation speed of the brushes was 200 rpm.

### (b) Alkaline etching treatment

Etching treatment was carried out by spraying an aqueous NaOH solution (NaOH concentration being 26% by weight and also containing an aluminum ion 6.5% by weight) to the aluminum plate at 70°C, to dissolve the aluminum sheet by an amount of 6 g/m². After that, the aluminum sheet was washed with water by spraying.

### (c) Desmut treatment

Desmut treatment was carried out by spraying an aqueous solution of 1% by weight nitric acid (containing an aluminum ion at concentration of 0.5% by weight) at 30°C, and then the resulting aluminum sheet was washed with water. As the aqueous nitric acid solution used for the desmutting, waste solution from a step of the electrochemical surface roughening in an aqueous nitric acid solution by AC (alternate current) was used.

### (d) Electrochemical surface roughening treatment

Electrochemical surface roughening treatment was be carried out continuously by using 60 Hz AC voltage. The electrolytic solution used in this case was an aqueous solution of nitric acid (the concentration being 10.5 g/L and also containing aluminum ion by 5 g/L) at 50°C. The electrochemical surface roughening was carried out using an AC power waveform which had a trapezoidal rectangular waveform, with the time TP from a zero current value to the peak being 0.8 msec and DutyUTY ratio 1:1, and employing a carbon electrode as an opposed electrode. Ferrite was used as an auxiliary anode. A radial cell type electrolytic bath was used.

The current density was 30 A/dm² at the peak value of the current and the total electricity quantity was 220 C/dm² when the aluminum sheet was used as an anode. Five percent of the electric current flowing from the electric power was shunted to the auxiliary anode.

After that, the resulting aluminum sheet was washed with a water spray.

### (e) Alkali etching treatment

Etching treatment was carried out at 32°C for the aluminum sheet at by spraying a solution with sodium hydroxide concentration 26% by weight and aluminum ion concentration 6.5% by weight onto the aluminum sheet. 0.2 g/m² of the aluminum sheet was dissolved, to remove the smut component of which main component was aluminum hydroxide produced during the electrochemical surface roughening by using alternating current in the prior step. The edge portions of the pits formed were dissolved to make the edge portions smooth. After that, the aluminum sheet was washed by spraying water spray.

### (f) Desmut treatment

Desmut treatment was carried out by spraying an aqueous solution of 15% by weight nitric acid (containing aluminum ion 4.5% by weight) at 30°C. Then the resulting aluminum sheet was washed by spraying water spray. As For the aqueous nitric acid solution used for the desmut, waste solution from the step of the electrochemical surface roughening with an aqueous nitric acid solution by AC was used.

### (g) Electrochemical surface roughening treatment

Electrochemical surface roughening treatment was carried out continuously by using 60 Hz AC voltage. The electrolytic solution used in this step was an aqueous solution of hydrochloric acid (the concentration thereof being 7.5 g/L and also containing aluminum ion by 5 g/L) at 35°C. The AC power waveform had a trapezoidal rectangular waveform and a carbon electrode was used as an opposed electrode, to effect the electrochemical surface roughening treatment. Ferrite was used as an auxiliary anode. A radial cell type electrolytic bath was used.

The current density was 25 A/dm² at the peak value of the current and the total electricity quantity was 50 C/dm² when the aluminum sheet was used as an anode.

After that, the resulting aluminum sheet was washed with a water spray.

### (h) Alkali etching treatment

Etching treatment was carried out at 32°C for the aluminum sheet by spraying a solution containing 26 wt. % sodium hydroxide and 6.5 wt. % aluminum ion thereon, to dissolve 0.10 g/m² of the aluminum sheet, so as to remove the smut, of which main component is mainly aluminum hydroxide produced during the electrochemical roughening treatment of the surface by using alternating current in the prior step. Further, the edge portions of the pits formed were dissolved to make the edge portions smooth. After that, the aluminum sheet was washed by spraying water spray.

### (i) Desmut treatment

Desmut treatment was is carried out by spraying with an aqueous solution of 25% by weight sulfuric acid (containing aluminum ion 0.5% by weight) at 60°C and then washing the resulting aluminum sheet was washed by spraying water spray.

### (j) Anodization treatment

As an electrolytic solution, sulfuric acid was used. The electrolytic solution contained sulfuric acid by 170 g/L (and contained aluminum ion 0.5% by weight). The temperature of the electrolytic solution was 43°C. After Then the aluminum sheet was washed with a water by spraying.

The electric current density was about 30 A/dm². Final oxide film thickness was about 2.7 g/m².

### <Support A>

Each of the foregoing (a) through (j) steps was sequentially carried out, and the amount of etching in the step (e) was controlled so as to be 3.4 g/m², such that support A was prepared.

### <Support B>

Support B was prepared by sequentially carrying out the aforementioned steps (a) to (j) but omitting the steps (g), (h) and (i).

### <Support C>

Respective steps were successively performed except that steps (a), (g), (h) and (i) among the aforementioned steps were omitted, a support was prepared.

### <Support D>

Respective steps were successively performed except that steps (a), (d), (e) and (f) among the aforementioned steps were omitted, a sum of an electricity amount in a (g) step was adjusted to be 450C/dm² to prepare a support.

Supports A, B, C and D as obtained above were subsequently subjected to the following hydrophilization treatment and undercoating treatment.

### (k) Alkali metal silicate salt treatment

An aluminum support obtained by anode oxidation treatment was immersed in a treatment bath containing 1 mass % aqueous solution of No. 3 sodium silicate at a temperature of 30°C for 10 seconds, thereby effecting alkali metal silicate salt treatment (silicate treatment). Thereafter, water washing by spraying using well water was performed. Thereupon, a silicate adhering amount was 3.6 mg/m².

### (Undercoating treatment)

An undercoating solution having the following composition was coated on the aluminum support thus obtained after alkali metal silicate salt treatment, and was dried at 80°C for 15 seconds. A covering amount after drying was 16 mg/m².

### <Undercoating solution composition>

- Following polymer compound 0.3 g
- Methanol 100 g
- Water 1.0 g

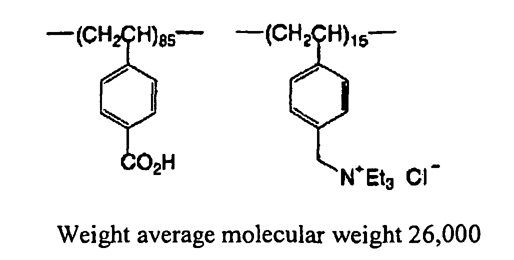

After a coating solution for a first layer (lower layer) having the following composition was applied onto substrate A using a wire bar, the substrate was dried in a drying oven at 150°C for 60 seconds such that the amount of coating was 0.85 g/m².

Then, a coating solution for a second layer (upper layer) having the following composition was applied, using a wire bar, onto the substrate having the first layer, and the substrate was dried in a drying oven at 145°C for 70 seconds such that the total amount of coating was 1.15 g/m², thus producing the positive planographic printing plate precursors of Examples 1 to 8 and Comparative Examples 1 and 2.

### <First layer (lower layer) coating solution>

- Copolymer 1 (synthesized according to the following description) 2.133 g
- Cyanine dye A (following structure) 0.098 g
- 2-Mercapto-5-methylthio-1,3,4-thiadiazole 0.030 g
- Cis-Δ⁴-tetrahydrophthalic acid anhydride 0.100 g
- 4,4'-Sulfonyldiphenol 0.090 g
- p-Toluenesulfonic acid 0.008 g
- Ethylviolet in which counter-anion was replaced with 6-hydroxynaphthalenesulfonic acid 0.100 g
- 3-Methoxy-4-diazodiphenylamine hexafluorophosphate 0.030 g
- Fluorine-based surfactant
   (trade name :Megafack F-780, manufactured by Dainippon Ink and Chemicals, Incorporated) 0.035 g
- Methyl ethyl ketone 26.6 g
- 1-Methoxy-2-propanol 13.6 g
- γ-Butyrolactone 13.8 g

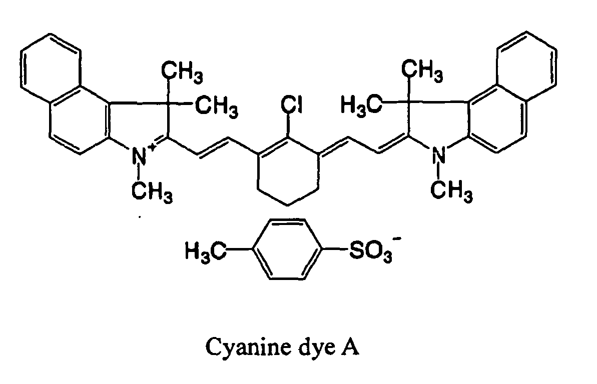

### <Synthesis of copolymer 1>

After stirring, 31.0 g (0.36 mole) of methacrylic acid, 39.1 g (0.36 mole) of ethyl chloroformate and 200 ml of acetonitrile were placed into a 500 ml three-neck flask equipped with a condenser and a dropping funnel, and the mixture was stirred while it was cooled in an ice-water bath. To this mixture was added dropwise 36.4 g (0.36 mole) of triethylamine by a dropping funnel over about 1 hour. After completion of addition, an ice-water bath was removed, and the mixture was stirred at room temperature for 30 minutes.

51.7 g (0.30 mole) of p-amiobenzenesulfonamide was added to this reaction mixture, and the mixture was stirred for 1 hour while it was warmed to 70°C in an oil bath. After completion of the reaction, this mixture was placed into 1 liter of water while the water was stirring, and the resulting mixture was stirred for 30 minutes. This mixture was filtered to take precipitates, which was slurried with 500 ml of water, the slurry was filtered, and the resulting solid was dried to obtain N-(p-aminosulfonylphenyl)methacrylamide as a white solid (yield 46.9 g).

Then, 4.61 g (0.0192 mole) of N-(p-aminosulfonylphenyl)methacrylamide, 2.58 g (0.0258 mole) of ethyl methacrylate, 0.80 g (0.015 mole) of acrylonitrile and 20 g of N-dimethylacetamide were placed into a 20 ml three-neck flask equipped with a stirrer, a condenser and a dropping funnel, and the mixture was stirred while it was heated to 65°C in a hot water bath. To this mixture was added 0.15 g of 2,2'-azobis(2,4-dimethylvaleronitrile) (trade name: V-65, manufactured by Wako Pure Chemical Industries, Ltd.) as a polymerization initiator, and the mixture was stirred for 2 hours under a nitrogen stream while a temperature was retained at 65°C. To this reaction mixture was added dropwise a mixture of 4.61 g of N-(p-aminosulfonylphenyl)methacrylamide, 2.58 g of methyl methacrylate, 0.80 g of acrylonitrile, 20 g of N,N-dimethylacetamide, and 0.15 g of V-65 with a dropping funnel over 2 hours. After completion of addition, the resulting mixture was stirred at 65°C for 2 hours. After completion of the reaction, 40 g of methanol was added to the mixture and cooled, and the resulting mixture was placed into 2 liter of water while the water was stirred, the mixture was stirred for 30 minutes, and precipitates were collected by filtration, and dried to obtain 15 g of a white solid. A weight average molecular weight (polystyrene standard) of this specific copolymer 1 was measured by gel permeation chromatography, and was found to be 54,000.

### <Second layer (upper layer) coating solution>

- Copolymer of ethyl methacrylate and 2-methacryloyloxyethylsuccinic acid
   (Mole ratio 67:33, weight average molecular weight 92,000) 0.030 g
- Novolak resin P1:phenolcresol-formaldehyde novolak
   (Phenol:m-cresol:p-cresol=30:30:40, weight average molecular weight:5500) 0.300 g
- Sulfonium salt (following structure) 0.1 g
- Cyanine dye A(following structure) 0.015 g
- Ethylviolet in which counter-anion thereof was replaced with 6-hydroxynaphthalenesulfonic acid 0.012 g
- Fluorine-based surfactant
   (trade name: Megafuck F-780, manufactured by Dainippon Ink and Chemicals, Incorporated) 0.011 g
- Methyl ethyl ketone 13.1 g
- 1-Methoxy-2-propanol 6.79 g
- Specific copolymer of the invention or comparative copolymer
   (compound described in Table 1) 0.055 g

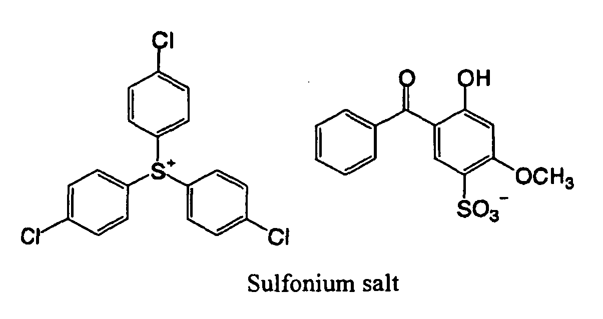

### [Assessment of positive planographic printing plate precursors]

The positive planographic printing plate precursors were assessed for the presence or absence of generation of sludge and inking property. Details of the assessment methods are as follows.

### 1. Presence or absence of generation of sludge

A planographic printing plate precursor (1 m²) was subjected to a full-surface light-exposure, and developed using a 200 cc of a developing solution for a PS plate (a developing solution substantially free of alkali metal silicates, trade name: DT-2, manufactured by Fuji Photo Film Co. Ltd.). It was assesed as to whether a sludge from the precipitate or aggregate originating from the particular polymer compound of the present invention was generated in the developing solution. When the generation of sludge could not be visually observed, it was assessed as "undetected"; and when the generation of sludge due to the precipiate or aggregate could be visually observed, it was assessed as "detected". The results are shown in Table 1 below.

### 2. Adhesion property

A planographic printing plate precursor was exposed imagewise using a Trend Setter 3244F (trade name, manufactured by CREO Inc., setter exposure 8.0 W, 150 rpm), and was developed using a developing solution for a PS plate (trade name: DT-2, manufactured by Fuji Photo Film Co. Ltd.). The planographic printing plate precursor was mounted on a printing machine, and the number of sheets required to obtain a printed product in which ink normally adhered without problems was assessed. As the number of sheets becomes smaller, the inking property is assessed to be better. The results are shown in Table 1 below.

**[Table 1]**

| | Particular polymer compound or comparative polymer compound | Generation of sludge | Inking property |
|---|---|---|---|
| Example 1 | P-1 | undetected | 20 |
| Example 2 | P-2 | undetected | 18 |
| Example 3 | P-3 | undetected | 18 |
| Example 4 | P-4 | undetected | 18 |
| Example 5 | P-6 | undetected | 10 |
| Example 6 | P-7 | undetected | 8 |
| Example 7 | P-8 | undetected | 14 |
| Example 8 | P-9 | undetected | 9 |
| Example 9 | P-15 | undetected | 13 |
| Example 10 | P-23 | undetected | 14 |
| Comparative Example 1 | AP-1 | detected | 37 |
| Comparative Example 2 | AP-2 | undetected | 35 |
| Comparative Example 3 | AP-4 | detected | 16 |
| Comparative Example 4 | AP-7 | detected | 34 |

As shown in Table 1, it is evidenced that the planographic printing plate precursors of Examples 1 to 10 have achieved an improvement of inking property and that sludge due to the precipitate was not generated in the developing solution in these Examples. On the other hand, compared to the planographic printing plate precursors of the Examples, it is evidenced that the generation of sludge due to the precipitate in the developing solution tended to easily occur in the planographic printing plate precursors of Comparative Examples 1 to 4 than in the planographic printing plate precursors of the Examples, and that inking property was significantly low in those Comparative Examples in which the generation of sludge tended not to occur. Therefore, it is recognized that use of the particular polymer compound is effective for striking a balance between inking property and suppression of generation of sludge in a developing solution.

### [Examples 11 to 20 and Comparative Examples 5 to 8]

In Examples 11 to 20 and Comparative Examples 5 to 8, the assessments were carried out in a similar manner to that for Examples 1 to 10 and Comparative Examples 1 to 4, except that a sulfonium salt was not used in the coating solution for the second layer (upper layer). The results are shown in Table 2.

**[Table 2]**

| | Particular polymer compound or comparative polymer compound | Generation of sludge | Inking property |
|---|---|---|---|
| Example 11 | P-1 | undetected | 22 |
| Example 12 | P-7 | undetected | 8 |
| Example 13 | P-8 | undetected | 12 |
| Example 14 | P-9 | undetected | 10 |
| Example 15 | P-14 | undetected | 10 |
| Example 16 | P-19 | undetected | 14 |
| Example 17 | P-20 | undetected | 8 |
| Example 18 | P-21 | undetected | 10 |
| Example 19 | P-22 | undetected | 10 |
| Example 20 | P-23 | undetected | 14 |
| Comparative Example 5 | AP-1 | detected | 30 |
| Comparative Example 6 | AP-3 | undetected | 32 |
| Comparative Example 7 | AP-5 | detected | 18 |
| Comparative Example 8 | AP-7 | detected | 30 |

As shown in Table 2, it is evidenced that the planographic printing plate precursors of Examples 11 to 20 have achieved improvements of inking property and suppression of the generation of sludge. On the other hand, it is evidenced that generation of sludge due to the precipitate in the developing solution tended to easily occur in the planographic printing plate precursors of Comparative Examples 5 to 8, which did not comprise the particular polymer compound, than in the planographic printing plate precursors of the Examples, and that inking property was significantly low in the cases of those Comparative Examples in which the generation of sludge tended not to occur. Therefore, it is recognized that use of the particular polymer compound is effective for striking a balance between inking property and suppression of generation of sludge in the developing solution. Furthermore, from these results, it is recognized that the effects of the present invention can be exhibited regardless of the presence or absence of a sulfonium salt in the recording layer.

### [Examples 21 to 28 and Comparative Examples 9 and 10]

On a substrate C thus obtained, a coating solution having the following composition was applied for a first layer (lower layer) using a wire bar, and the substrate was dried in a drying oven at 130°C for 60 seconds to make the coated amount 0.60 g/m².

A coating solution for a second layer (upper layer) having the following composition was applied on the thus-obtained substrate having the lower layer using a wire bar, and the substrate was then dried in a drying oven at 150°C for 60 seconds to make the total coated amount 1.25 g/m², thus producing the positive planographic printing plate precursors of Examples 21 to 28 and Comparative Examples 9 and 10.

### <Coating solution for the first layer (lower layer)>

- The above-mentioned copolymer 1 2.133 g
- Cyanine dye A (having the above-mentioned structure) 0.098 g
- 2-Mercapto-5-methylthio-1,3,4-thiadiazole 0.030 g
- Cis-Δ⁴-tetrahydrophthalate anhydride 0.100 g
- 4,4'-Sulfonyldiphenol 0.090 g
- p-Toluenesulfonic acid 0.008 g
- Compound obtained by replacing counteranion of Ethyl Violet with 6-hydroxynaphthalenesulfonic acid 0.100 g
- 3-Methoxy-4-diazodiphenylaminehexafluorophosphate 0.030 g
- Fluorine-based surfactant
   (trade name: Megafac F-780, manufactured by Dainippon Ink and Chemicals Inc.) 0.035 g
- Methyl ethyl ketone 26.6 g
- 1-Methoxy-2-propanol 13.6 g
- Dimethylsulfoxide 13.8 g

### <Coating solution for the second layer (upper layer)>

- Copolymer of ethyl methacrylate and 2-methacryloyloxyethyl succinate
   (Molar ratio 67:33, weight-average molecular weight 92,000) 0.030 g
- Novolak resin P1: phenolcresol-formaldehyde novolak
   (phenol:m-cresol:p-cresol=30:30:40, weight-average molecular weight: 5500) 0.300 g
- Sulfonium salt (having the above-mentioned structure) 0.1 g
- Cyanine dye A (having the above-mentioned structure) 0.015 g
- Compound obtained by replacing a counteranion of Ethyl Violet with 6-hydroxynaphthalenesulfonic acid 0.012 g
- Fluorine-based surfactant
   (trade name: Megafac F-780, manufactured by Dainippon Ink and Chemicals Inc.) 0.011 g
- Methylethylketone 13.1 g
- 1-Methoxy-2-propanol 6.79 g
- Particular polymer compound or comparative polymer compound
   (synthesized by the above-mentioned method, compounds described in Table 3) 0.055 g

### <Assessment of Examples 21 to 28 and Comparative Examples 9 and 10>

The thus-obtained planographic printing plate precursors of Examples 21 to 28 and Comparative Examples 9 and 10 were assessed in a manner similar to that for Example 1.

**[Table 3]**

| | Particular polymer compound or comparative polymer compound | Generation of sludge | Inking property |
|---|---|---|---|
| Example 21 | P-1 | undetected | 20 |
| Example 22 | P-7 | undetected | 7 |
| Example 23 | P-10 | undetected | 10 |
| Example 24 | P-14 | undetected | 10 |
| Example 25 | P-18 | undetected | 8 |
| Example 26 | P-24 | undetected | 12 |
| Example 27 | P-25 | undetected | 10 |
| Example 28 | P-27 | undetected | 16 |
| Comparative Example 9 | AP-2 | undetected | 34 |
| Comparative Example 10 | AP-4 | detected | 17 |

As shown in Table 3, it is evidenced that the planographic printing plate precursors of Examples 21 to 28 have achieved an improvement of inking property and that sludge due to the precipitate was not generated in the developing solution for these Examples. On the other hand, it is evidenced that generation of sludge due to the precipitate in the developing solution tended to easily occur in the planographic printing plate precursors of Comparative Examples 9 and 10, which did not comprise the particular polymer compound in the recording layer, than in the planographic printing plate precursors of the Examples, and that inking property was significantly low in those Comparative Examples in which the generation of sludge tended not to occur. Therefore, it is recognized that use of the particular polymer compound is effective for striking a balance between inking property and the suppression of generation of sludge in a developing solution.

### [Examples 29 to 36 and Comparative Examples 11 and 12]

In Examples 29 to 36 and Comparative Examples 11 and 12, the assessments were carried out in manner similar to that for Examples 21 to 28 and Comparative Examples 9 and 10, except that a sulfonium salt was not used in the coating solution for the second layer (upper layer). The results are shown in Table 4.

**[Table 4]**

| | Particular polymer compound or comparative polymer compound | Generation of sludge | Inking property |
|---|---|---|---|
| Example 29 | P-1 | undetected | 21 |
| Example 30 | P-5 | undetected | 12 |
| Example 31 | P-7 | undetected | 7 |
| Example 32 | P-10 | undetected | 8 |
| Example 33 | P-18 | undetected | 7 |
| Example 34 | P-20 | undetected | 8 |
| Example 35 | P-21 | undetected | 9 |
| Example 36 | P-22 | undetected | 13 |
| Comparative Example 11 | AP-3 | undetected | 32 |
| Comparative Example 12 | AP-5 | detected | 18 |

As shown in Table 4, it is evidenced that the planographic printing plate precursors of Examples 29 to 36 have achieved an improvement of inking property and that sludge due to the precipitate was not generated in the developing solution in these Examples. On the other hand, it is evidenced that generation of sludge due to the precipitate in the developing solution tended easily occur in the planographic printing plate precursors of Comparative Examples 11 and 12, which did not comprise the particular polymer compound in the recording layer, than in the planographic printing plate precursors of the Examples, and that inking property was significantly low in those Comparative Examples in which the generation of sludgetended not to occur. Therefore, it is recognized that use of the particular polymer compound is effective for striking a balance between inking property and the suppression of generation of sludge in a developing solution.

### [Examples 37 to 44 and Comparative Examples 13 and 14]

A coating solution for a first layer (lower layer) having the following composition was applied on a substrate D thus obtained using a wire bar, and the substrate was dried in a drying oven at 150°C for 60 seconds to make the coated amount 0.81 g/m².

A coating solution for a second layer (upper layer) having the following composition was applied on the thus-obtained substrate having the lower layer using a wire bar, and the substrate was dried in a drying oven at 150°C for 60 seconds to make the total coated amount 0.99 g/m², thus producing the positive planographic printing plate precursors of Examples 37 to 44 and Comparative Examples 13 and 14.

### <Coating solution for the first layer (lower layer)>

- The above-mentioned copolymer 1 2.133 g
- Cyanine dye A (having the above-mentioned structure) 0.098 g
- Cis-Δ⁴-tetrahydrophthalate anhydride 0.110 g
- 4,4'-Sulfonyldiphenol 0.090 g
- p-Toluenesulfonic acid 0.008 g
- Compound obtained by replacing a counteranion of Ethyl Violet with 6-hydroxynaphthalenesulfonic acid 0.100 g
- 3-Methoxy-4-diazodiphenylaminehexafluorophosphate 0.030 g
- Fluorine-based surfactant (trade name: Megafac F-780, manufactured by Dainippon Ink and Chemicals Inc.) 0.035 g
- Methyl ethyl ketone 26.6 g
- 1-Methoxy-2-propanol 13.6 g
- γ-Butyrolactone 13.8 g

### <Coating solution for the second layer (upper layer)>

- Copolymer of ethyl methacrylate and 2-methacryloyloxyethyl succinate
   (Molar ratio 67:33, weight-average molecular weight 92,000) 0.030 g
- Novolak resin P5: phenolcresol-formaldehyde novolak
   (phenol:m-cresol:p-cresol=40:40:20, weight-average molecular weight 8000) 0.300 g
- Sulfonium salt (having the above-mentioned structure) 0.020 g
- Cyanine dye A (having the above-mentioned structure) 0.015 g
- Fluorine-based surfactant
   (trade name: Megafac F-780, manufactured by Dainippon Ink and Chemicals Inc.) 13.1 g
- 1-Methoxy-2-propanol 6.79 g
- Particular polymer compound or comparative polymer compound
   (synthesized by the above-mentioned method, compounds described in Table 5) 0.055 g

### <Assessment of Examples 37 to 44 and Comparative Examples 13 and 14>

The planographic printing plate precursors thus obtained were assessed ina manner similar to that for Example 1, except that a developing solution for a PS plate (a developing solution comprising an alkali metal silicate, trade name: DP-4, manufactured by Fuji Photo Film Co. Ltd.) was used.

**[Table 5]**

| | Particular polymer compound or comparative polymer compound | Generation of sludge | Inking property |
|---|---|---|---|
| Example 37 | P-1 | undetected | 20 |
| Example 38 | P-7 | undetected | 8 |
| Example 39 | P-12 | undetected | 12 |
| Example 40 | P-15 | undetected | 12 |
| Example 41 | P-22 | undetected | 13 |
| Example 42 | P-24 | undetected | 15 |
| Example 43 | P-25 | undetected | 12 |
| Example 44 | P-26 | undetected | 9 |
| Comparative Example 13 | AP-2 | undetected | 32 |
| Comparative Example 14 | AP-4 | detected | 17 |

As shown in Table 5, it is evidenced that the planographic printing plate precursors of Examples 37 to 44 have achieved an improvement of inking property and that sludge due to the precipitate in the developing solution was not generated in these Examples. On the other hand, it is evidenced that generation of sludge due to the precipitate in the developing solution tended to easily occur in the planographic printing plate precursors of Comparative Examples 13 and 14, which did not comprise the particular polymer compound in the recording layer, than in the planographic printing plate precursors of the Examples, and that inking property was significantly low in those Comparative Examples in which the generation of sludge tended not to occur. Therefore, it is recognized that use of the particular polymer compound is effective for striking a balance between inking property and the suppression of generation of sludge in the developing solution.

### [Examples 45 to 52 and Comparative Examples 15 and 16]

In Examples 45 to 52 and Comparative Examples 15 and 16, the assessments were carried out in a manner similar to that for Examples 37 to 44 and Comparative Examples 13 and 14, except that a sulfonium salt was not used in a coating solution for a second layer (upper layer). The results are shown in Table 6.

**[Table 6]**

| | Particular polymer compound or comparative polymer compound | Generation of sludge | Inking property |
|---|---|---|---|
| Example 45 | P-1 | undetected | 17 |
| Example 46 | P-3 | undetected | 16 |
| Example 47 | P-5 | undetected | 13 |
| Example 48 | P-7 | undetected | 7 |
| Example 49 | P-9 | undetected | 9 |
| Example 50 | P-11 | undetected | 11 |
| Example 51 | P-13 | undetected | 12 |
| Example 52 | P-15 | undetected | 11 |
| Comparative Example 15 | AP-3 | undetected | 29 |
| Comparative Example 16 | AP-5 | detected | 18 |

As shown in Table 6, it is evidenced that the planographic printing plate precursors of Examples 45 to 52 have achieved an improvement of inking property and that sludge due to the precipitate in the developing solution was not generated in these Examples. On the other hand, it is evidenced that the generation of sludge due to the precipitate in the developing solution tended to easily occur in the planographic printing plate precursors of Comparative Examples 15 and 16, which did not comprise the particular polymer compound in the recording layer, than in the planographic printing plate precursors of the Examples, and that inking property was significantly low in those Comparative Examples in which the generation of sludge tended not to occur. Therefore, it is recognized that use of the particular polymer compound is effective for striking a balance between inking property and the suppression of generation of sludge in a developing solution.

### [Examples 53 to 60 and Comparative Examples 17 and 18]

A coating solution for an image-forming layer having the following composition was applied on a substrate D which was previously obtained, and the substrate was dried in a drying oven at 150°C for 1 minute to form an image-forming layer to provide the planographic printing plate precursors of Examples 53 to 60 and Comparative Examples 17 and 18. The coated amount after drying was 1.55 g/m².

### <Coating solution for an image-forming layer (recording layer)>

- Novolak resin P7: phenolcresol-formaldehyde novolak
   (phenol:m-cresol:p-cresol=20:60:20, weight-average molecular weight 10200) 1.0 g
- Cyanine dye A (having the above-mentioned structure) 0.05 g
- Compound obtained by replacing counteranion of Victoria Pure Blue BOH with 1-naphthalenesulfonic acid 0.01 g
- Fluorine-based surfactant
   (trade name: Megafac F-177, manufactured by Dainippon Ink and Chemicals Incorporated) 0.05 g
- Methyl ethyl ketone 9.0 g
- 1-Methoxy-2-propanol 9.0 g
- Particular polymer compound or comparative polymer compound
   (synthesized by the above-mentioned method, compounds described in Table 7) 0.2 g

### <Assessment of Examples 53 to 60 and Comparative Examples 17 and 18>

The planographic printing plate precursors thus obtained were assessed in a manner similar to that for Example 1, except that a developing solution for a PS plate (a developing solution comprising an alkali metal silicate, trade name: DP-4, manufactured by Fuji Photo Film Co. Ltd.) was used.

**[Table 7]**

| | Particular polymer compound or comparative polymer compound | Generation of sludge | Inking property |
|---|---|---|---|
| Example 53 | P-1 | undetected | 18 |
| Example 54 | P-4 | undetected | 17 |
| Example 55 | P-7 | undetected | 7 |
| Example 56 | P-10 | undetected | 8 |
| Example 57 | P-13 | undetected | 11 |
| Example 58 | P-17 | undetected | 12 |
| Example 59 | P-21 | undetected | 10 |
| Example 60 | P-27 | undetected | 12 |
| Comparative Example 17 | AP-3 | undetected | 27 |
| Comparative Example 18 | AP-5 | detected | 17 |

As shown in Table 7, it is evidenced that the planographic printing plate precursors of Examples 53 to 60 have achieved an improvement of inking property and that sludge due to the precipitate was not generated in the developing solution in these Examples. On the other hand, it is evidenced that the generation of sludge due to the precipitate in the developing solution tended to easily occur in the planographic printing plate precursors of Comparative Examples 17 and 18 than in the planographic printing plate precursors of the Examples, and that inking property was significantly low in those Comparative Examples in which the generation of sludge tended not to occur. Therefore, it is recognized that use of the particular polymer compound is effective for striking a balance between inking property and the suppression of generation of sludge in the developing solution. Therefore, it is recognized that use of the specific polymer compound of the invention is effective for striking a balance between inking property and the suppression of generation of sludge in a developing solution.

## Claims

1. A photosensitive planographic printing plate precursor comprising:
a substrate, and
a recording layer provided on the substrate;
wherein the recording layer comprises an infrared-light absorbing agent, and a polymer compound having a partial structure comprising (1) silicon-oxygen bonds and a partial structure comprising (2) alkali-soluble groups.

2. A photosensitive planographic printing plate precursor according to Claim 1, wherein:
the recording layer is comprised of a lower layer and an upper layer, provided in that order on the substrate,
the lower layer comprising an alkali-soluble resin, and
the upper layer comprising the polymer compound, an alkali-soluble resin and a compound which interacts with the alkali-soluble resin to reduce the solubility of the resin in an aqueous alkali solution and loses the effect of the interaction upon irradiation with infrared light.

3. A photosensitive planographic printing plate precursor according to Claim 1 or Claim 2, wherein the (1) silicon-oxygen bonds are part of a main chain of the polymer compound.

4. A photosensitive planographic printing plate precursor according to Claim 1 or Claim 2, wherein the (1) silicon-oxygen bonds are part of a side chain of the polymer compound.

5. A photosensitive planographic printing plate precursor according to any preceding Claim, wherein the (1) silicon-oxygen bonds are included as a repeating structure, of which three or more are present, in the polymer compound.

6. A photosensitive planographic printing plate precursor according to Claim 5, wherein the (1) silicon-oxygen bonds are included as a repeating structure, of which 5 to 10,000 are present, in the polymer compound.

7. A photosensitive planographic printing plate precursor according to Claim 6, wherein the (1) silicon-oxygen bonds are included as a repeating structure, of which 8 to 2,000 are present, in the polymer compound.

8. A photosensitive planographic printing plate precursor according to any preceding Claim, wherein the (1) silicon-oxygen bonds are included as a repeating structure in the polymer compound, and the concentration of silicon in the recording layer is higher at the surface of the recording layer than in the vicinity of the substrate.

9. A photosensitive planographic printing plate precursor according to any preceding Claim, wherein the partial structure comprising the (1) silicon-oxygen bonds further comprises a lipophilic group.

10. A photosensitive planographic printing plate precursor according to Claim 9, wherein the lipophilic group is an alkyl group, an alkenyl group, an alkynyl group, an aryl group or a heterocyclic group, each of which may have a substituent.

11. A photosensitive planographic printing plate precursor according to any preceding Claim, wherein the content of silicon atoms in the polymer compound is 1.0 mmol/g or more.

12. A photosensitive planographic printing plate precursor according to any preceding Claim, wherein the polymer compound comprises, as a copolymerisation component, a monomer comprising one or more acid groups selected from a phenol group (-Ar-OH), a sulphonamide group (-SO₂NH-R), a substituted sulphonamide-based acid group (-SO₂-NHCOR, -SO₂NHSO₂R, -CONHSO₂R), a carboxylic acid group (-CO₂H), a sulphonic acid group (-SO₃H), or a phospholic acid group (-OPO₃H₂), wherein Ar is an optionally substituted bivalent aryl linking group and R is a hydrogen atom or an optionally substituted hydrocarbon group.

13. A photosensitive planographic printing plate precursor according to any preceding claim, wherein the polymer compound comprises, as a copolymerisation component, a repeating unit represented by formula (I): 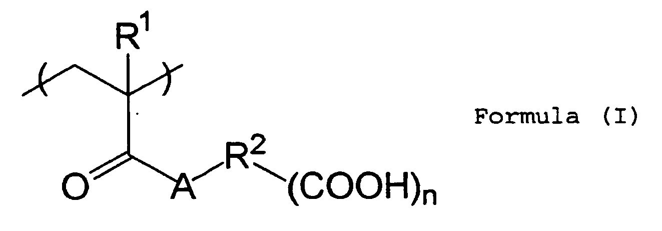 wherein R¹ is a hydrogen atom or a methyl group; the linking group represented by R² is a hydrocarbon group having a valency of (n+1) and having an alicyclic structure that has 3 to 30 carbon atoms; A is an oxygen atom, -NH- or -NR³-, wherein R³ is a hydrogen atom or a monovalent hydrocarbon group having 1-10 carbon atoms; and n is an integer from 1 to 5.

## Patentansprüche

1. Fotoempfindlicher Planographie-Druckplattenvorläufer umfassend:
ein Substrat und
eine Aufzeichnungsschicht, die auf das Substrat aufgebracht ist,
wobei die Aufzeichnungsschicht ein Infrarotlicht absorbierendes Mittel und eine Polymerverbindung mit einer Teilstruktur umfassend (1) Silizium-Sauerstoff-Bindungen und einer Teilstruktur umfassend (2) Alkalilösliche Gruppen umfaßt.

2. Fotoempfindlicher Planographie-Druckplattenvorläufer gemäß Anspruch 1 wobei:
die Aufzeichnungsschicht aus einer unteren Schicht und einer oberen Schicht besteht, die in dieser Reihenfolge auf dem Substrat angeordnet sind,
die untere Schicht ein Alkali-lösliches Harz umfaßt und
die obere Schicht die Polymerverbindung, ein Alkali-lösliches Harz und eine Verbindung umfaßt, die mit dem Alkali-löslichen Harz in Wechselwirkung tritt, um die Löslichkeit des Harzes in einer wäßrigen Alkalilösung zu vermindern, und die bei Bestrahlung mit Infrarotlicht die Wirkung der Wechselwirkung verliert.

3. Fotoempfindlicher Planographie-Druckplattenvorläufer gemäß Anspruch 1 oder Anspruch 2, wobei die (1) Silizium-Sauerstoff-Bindungen Teil einer Hauptkette der Polymerverbindung sind.

4. Fotoempfindlicher Planographie-Druckplattenvorläufer gemäß Anspruch 1 oder Anspruch 2, wobei die (1) Silizium-Sauerstoff-Bindungen Teil einer Seitenkette der Polymerverbindung sind.

5. Fotoempfindlicher Planographie-Druckplattenvorläufer gemäß einem der vorstehenden Ansprüche, wobei die (1) Silizium-Sauerstoff-Bindungen als eine sich wiederholende Struktur, von der drei oder mehr vorliegen, in der Polymerverbindung umfaßt sind.

6. Fotoempfindlicher Planographie-Druckplattenvorläufer gemäß Anspruch 5, wobei die (1) Silizium-Sauerstoff-Bindungen als eine sich wiederholende Struktur, von der 5 bis 10.000 vorliegen, in der Polymerverbindung umfaßt sind.

7. Fotoempfindlicher Planographie-Druckplattenvorläufer gemäß Anspruch 6, wobei die (1) Silizium-Sauerstoff-Bindungen als eine sich wiederholende Struktur, von der 8 bis 2.000 vorliegen, in der Polymerverbindung umfaßt sind.

8. Fotoempfindlicher Planographie-Druckplattenvorläufer gemäß einem der vorstehenden Ansprüche, wobei die (1) Silizium-Sauerstoff-Bindungen als eine sich wiederholende Struktur in der Polymerverbindung umfaßt sind und die Konzentration des Siliziums in der Aufzeichnungsschicht an der Oberfläche der Aufzeichnungsschicht höher ist als in der Nähe des Substrats.

9. Fotoempfindlicher Planographie-Druckplattenvorläufer gemäß einem der vorstehenden Ansprüche, wobei die Teilstruktur umfassend die (1) Silizium-Sauerstoff-Bindungen ferner eine lipophile Gruppe umfaßt.

10. Fotoempfindlicher Planographie-Druckplattenvorläufer gemäß Anspruch 9, wobei die lipophile Gruppe eine Alkylgruppe, eine Alkenylgruppe, eine Alkinylgruppe, eine Arylgruppe oder eine heterocyclische Gruppe ist, die jeweils einen Substituenten aufweisen kann.

11. Fotoempfindlicher Planographie-Druckplattenvorläufer gemäß einem der vorstehenden Ansprüche, wobei der Gehalt an Siliziumatomen in der Polymerverbindung 1,0 mmol/g oder mehr beträgt.

12. Fotoempfindlicher Planographie-Druckplattenvorläufer gemäß einem der vorstehenden Ansprüche, wobei die Polymerverbindung als eine Copolymerisationskomponente ein Monomer umfassend eine oder mehr Säuregruppen umfaßt, die ausgewählt sind aus einer Phenolgruppe (-Ar-OH), einer Sulfonamidgruppe (-SO₂NH-R) einer substituierten Säuregruppe auf Sulfonamidbasis (-SO₂-NHCOR, -SO₂NHSO₂R, -CONHSO₂R), einer Carbonsäuregruppe (-CO₂H), einer Sulfonsäuregruppe (-SO₃H) oder einer Phosphorsäuregruppe (-OPO₃H₂), wobei Ar eine gegebenenfalls substituierte divalente Arylverbindungsgruppe ist und R ein Wasserstoffatom oder eine gegebenenfalls substituierte Kohlenwasserstoffgruppe ist.

13. Fotoempfindlicher Planographie-Druckplattenvorläufer gemäß einem der vorstehenden Ansprüche, wobei die Polymerverbindung als eine Copolymerisationskomponente eine sich wiederholende Einheit umfaßt, die durch die Formel (I) dargestellt wird: 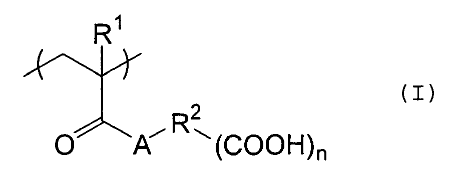 wobei R¹ ein Wasserstoffatom oder eine Methylgruppe ist, die durch R² dargestellte Verbindungsgruppe eine Kohlenwasserstoffgruppe mit einer Wertigkeit von (n+1) und einer alicyclischen Struktur mit 3 bis 30 Kohlenstoffatomen ist, A ein Sauerstoffatom, -NH- oder -NR³- ist, wobei R³ ein Wasserstoffatom oder eine einwertige Kohlenwasserstoffgruppe mit 1 bis 10 Kohlenstoffatomen ist, und n eine ganze Zahl von 1 bis 5 ist.

## Revendications

1. Précurseur de plaque d'impression planographique photosensible comprenant :
un substrat, et
une couche d'enregistrement disposée sur le substrat ;
dans lequel la couche d'enregistrement comprend un agent absorbant une lumière infrarouge, et un composé polymère ayant une structure partielle comprenant des liaisons oxygène-silicium (1) et une structure partielle comprenant des groupes solubles en milieu alcalin (2).

2. Précurseur de plaque d'impression planographique photosensible selon la revendication 1, dans lequel :
la couche d'enregistrement se compose d'une couche inférieure et d'une couche supérieure, disposées dans cet ordre sur le substrat,
la couche inférieure comprenant une résine soluble en milieu alcalin, et
la couche supérieure comprenant le composé polymère, une résine soluble en milieu alcalin et un composé qui interagit avec la résine soluble en milieu alcalin pour réduire la solubilité de la résine dans une solution alcaline aqueuse et perd l'effet de l'interaction lors d'une irradiation par une lumière infrarouge.

3. Précurseur de plaque d'impression planographique photosensible selon la revendication 1 ou la revendication 2, dans lequel les liaisons oxygène-silicium (1) font partie d'une chaîne principale du composé polymère.

4. Précurseur de plaque d'impression planographique photosensible selon la revendication 1 ou la revendication 2, dans lequel les liaisons oxygène-silicium (1) font partie d'une chaîne latérale du composé polymère.

5. Précurseur de plaque d'impression planographique photosensible selon l'une quelconque des revendications précédentes, dans lequel les liaisons oxygène-silicium (1) sont incluses en tant que structure répétitive, dont trois ou plus sont présentes, dans le composé polymère.

6. Précurseur de plaque d'impression planographique photosensible selon la revendication 5, dans lequel les liaisons oxygène-silicium (1) sont incluses en tant que structure répétitive, dont 5 à 10 000 sont présentes, dans le composé polymère.

7. Précurseur de plaque d'impression planographique photosensible selon la revendication 6, dans lequel les liaisons oxygène-silicium (1) sont incluses en tant que structure répétitive, dont 8 à 2 000 sont présentes, dans le composé polymère.

8. Précurseur de plaque d'impression planographique photosensible selon l'une quelconque des revendications précédentes, dans lequel les liaisons oxygène-silicium (1) sont incluses en tant que structure répétitive dans le composé polymère, et la concentration du silicium dans la couche d'enregistrement est plus élevée à la surface de la couche d'enregistrement qu'au voisinage du substrat.

9. Précurseur de plaque d'impression planographique photosensible selon l'une quelconque des revendications précédentes, dans lequel la structure partielle comprenant les liaisons oxygène-silicium (1) comprend en outre un groupe lipophile.

10. Précurseur de plaque d'impression planographique photosensible selon la revendication 9, dans lequel le groupe lipophile est un groupe alkyle, un groupe alcényle, un groupe alcynyle, un groupe aryle ou un groupe hétérocyclique, chacun d'eux pouvant avoir un substituant.

11. Précurseur de plaque d'impression planographique photosensible selon l'une quelconque des revendications précédentes, dans lequel la teneur en atomes de silicium dans le composé polymère est de 1,0 mmole/g ou davantage.

12. Précurseur de plaque d'impression planographique photosensible selon l'une quelconque des revendications précédentes, dans lequel le composé polymère comprend, en tant que composant de copolymérisation, un monomère comprenant un ou plusieurs groupes acides sélectionnés parmi un groupe phénol (-Ar-OH), un groupe sulfonamide (-SO₂NH-R) un groupe acide à base de sulfonamide substitué (-SO₂-NHCOR, -SO₂NHSO₂R, -CONHSO₂R), un groupe acide carboxylique (-CO₂H), un groupe acide sulfonique (-SO₃H), ou un groupe acide phospholique (-OPO3H2), Ar étant un groupe de liaison aryle divalent optionnellement substitué et R étant un atome d'hydrogène ou un groupe hydrocarboné optionnellement substitué.

13. Précurseur de plaque d'impression planographique photosensible selon l'une quelconque des revendications précédentes, dans lequel le composé polymère comprend, en tant que composant de copolymérisation, une unité répétitive représentée par la formule (I) : 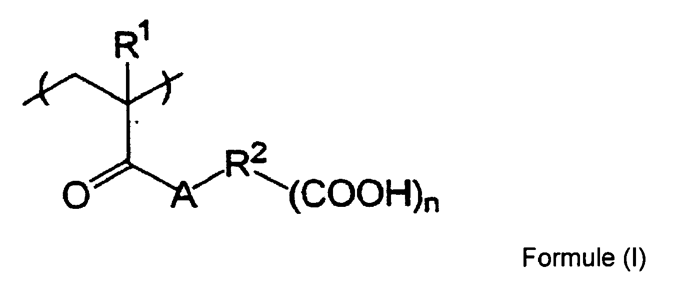 dans laquelle R¹ est un atome d'hydrogène ou un groupe méthyle ; le groupe de liaison représenté par R² est un groupe hydrocarboné ayant une valence de (n+1) et ayant une structure alicyclique qui a 3 à 30 atomes de carbone ; A est un atome d'oxygène, -NH- ou -NR³-, R³ étant un atome d'hydrogène ou un groupe hydrocarboné monovalent ayant 1 à 10 atomes de carbone ; et n est un nombre entier de 1 à 5.
